(19) Europäisches Patentamt / European Patent Office / Office européen des brevets

(11) **EP 4 360 245 B1**

(12) **EUROPEAN PATENT SPECIFICATION**

(45) Date of publication and mention
of the grant of the patent:
**21.05.2025 Bulletin 2025/21**

(21) Application number: **21759312.8**

(22) Date of filing: **16.08.2021**

(51) International Patent Classification (IPC):
**H04L 7/00** *(2006.01)*        **H03L 7/095** *(2006.01)*

(52) Cooperative Patent Classification (CPC):
**H04L 7/0004; H03L 7/0807; H03L 7/095;**
H04L 7/0029; H04L 7/0062; H04L 7/0334

(86) International application number:
**PCT/EP2021/072708**

(87) International publication number:
**WO 2023/020677 (23.02.2023 Gazette 2023/08)**

(54) **TIMING RECOVERY LOCK DETECTOR, SIGNAL RECEIVER APPARATUS, AND METHOD OF DETECTING TIMING RECOVERY LOCK**

DETEKTOR DER EINRASTUNG EINER TAKTRÜCKGEWINNUNG, SIGNALEMPFANGSVORRICHTUNG UND VERFAHREN ZUR DETEKTION DER EINRASTUNG EINER TAKTRÜCKGEWINNUNG

DÉTECTEUR DE VERROUILLAGE DE LA RÉCUPÉRATION D'HORLOGE, APPAREIL RÉCEPTEUR DE SIGNAUX, ET PROCÉDÉ DE DÉTECTION DU VERROUILLAGE DE LA RÉCUPÉRATION D'HORLOGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**01.05.2024 Bulletin 2024/18**

(73) Proprietor: **Huawei Technologies Co., Ltd.
Longgang
Shenzhen, Guangdong 518129 (CN)**

(72) Inventor: **STOJANOVIC, Nebojsa
80992 Munich (DE)**

(74) Representative: **Isarpatent
Patent- und Rechtsanwälte
Barth Hassa Peckmann & Partner mbB
Friedrichstraße 31
80801 München (DE)**

(56) References cited:
**WO-A1-2007/045071        US-A1- 2001 005 164
US-B2- 8 816 776**

**EP 4 360 245 B1**

**Description**

TECHNICAL FIELD

The present disclosure relates generally to the field of digital systems; and more specifically, to a timing recovery lock detector circuit for a signal receiver apparatus, a signal receiver apparatus, and a method of detecting a timing recovery lock in the signal receiver apparatus.

BACKGROUND

Generally, commercial optical systems are based on pulse amplitude modulation (PAM) or quadrature amplitude modulation (QAM). Typically, PAM-n modulation formats, such as PAM-2 and PAM-4, are used in cheap low-complexity non-coherent systems to cover short distances (e.g., up to 100 km), while n-QAM modulation formats, such as 4-QAM, 16-QAM, and 32-QAM, are utilized in more expensive coherent systems and cover much longer distances. However, the forecasted traffic demands in the near future require high-bandwidth, low-noise optical and electrical components, and high-order modulation formats, which are very sensitive to any transmission impairments.
Conventionally, advanced digital signal processing (DSP) is used in faster than Nyquist (FTN) systems to provide a solution to minimize the requirements on component bandwidth. However, in such severely bandwidth-limited systems, DSP relies on advanced equalization algorithms to enable data recovery. Thus, timing recovery (TR) design becomes very critical. Moreover, conventional timing recovery systems require very sophisticated algorithms, such as advanced timing phase detection, TR equalization, TR lock detection, and accurate TR loop design.
In certain scenarios, a conventional Gardner phase detector may be used in the conventional timing recovery systems. However, the conventional Gardner phase detector requires 2 samples per symbol (i.e., 2 sps). Alternatively stated, the timing error detector characteristic (TEDC) of the conventional Gardner phase detector, which is normalized to be one (i.e., the normalized value of 1) at the maximum, consists of two TR samples, i.e., a sampling phase (SP) and a lock detector sampling phase (LDSP). A lock detector level (LDL) is introduced in the conventional timing recovery system according to a predetermined lock detector threshold. LDSP samples are processed by the conventional Gardner phase detector, averaged and compared to LDL. The locking is announced when the LDL is crossed. However, the disadvantages of such conventional timing recovery systems are high sampling rate and the LDL level setting as it depends on noise and inter symbol interference (ISI). In another scenario, the conventional timing recovery systems monitor the signal/constellation points in a certain region and use another LDL, which is not very sensitive to channel impairments. However, if the signal is not well equalized (e.g., ISI is partially compensated), such conventional timing recovery systems may fail. Thus, there exists a technical problem of inefficiency and unreliability in conventional timing recovery systems to efficiently and reliably detect synchronization under impairments, such as ISI, noise, large clock offset, and jitter.
Therefore, in light of the foregoing discussion, there exists a need to overcome the aforementioned drawbacks associated with the conventional timing recovery systems.

SUMMARY

The present disclosure provides a timing recovery lock detector circuit for a signal receiver apparatus, a signal receiver apparatus, and a method of detecting a timing recovery lock in a signal receiver apparatus. The present disclosure provides a solution to the existing problem of inefficiency and unreliability in conventional timing recovery systems to efficiently and reliably detect synchronization under impairments, such as ISI, noise, large clock offset, and jitter. An aim of the present disclosure is to provide a solution that overcomes at least partially the problems encountered in prior art, and provides an improved timing recovery lock detector circuit and method for timing recovery lock in a signal receiver apparatus that is applicable for coherent as well as non-coherent systems by using either a phase detector (PD) or a phase-frequency detector (PFD) for clock extraction. Further, the method can detect successful clock acquisition in both oversampled and single-sample per symbol systems. Further, the method serves as a loss of lock detector for detecting inappropriate timing recovery working after declared clock acquisition. Moreover, the method does not depend on channel conditions, i.e., the lock detector is independent of ISI, noise, and other channel distortions.
One or more objects of the present disclosure is achieved by the solutions provided in the enclosed independent claims. Advantageous implementations of the present disclosure are further defined in the dependent claims.
In one aspect, the present disclosure provides a timing recovery lock detector circuit (LD) for a signal receiver apparatus. The timing recovery lock detector circuit is configured to receive a quantised signal from an analog-to-digital convertor (ADC) of the signal receiver apparatus, the quantised signal having a periodic unit interval (UI); generate at least one sample at a sampling point in the range of T= -0.25 UI to T= +0.25 UI of the quantised signal; perform a subtraction operation between two samples generated from the quantised signal; increment a timing lock counter if a result of the subtraction operation is positive; increment a reset counter if the result of the subtraction operation is negative, and reset the timing lock counter if the reset counter is above a reset threshold value; determine, if the timing lock counter is above a lock threshold value, that a timing recovery circuit of the signal receiver apparatus is locked; and generate an output signal in response to determining that the timing recovery circuit is locked.

The timing recovery lock detector circuit of the present disclosure generates two samples and compute their difference to provide information about the timing recovery status, i.e., whether the timing recovery circuit is locked or unlocked (loss of lock). The timing recovery lock detector circuit is applicable for coherent as well as non-coherent systems by using either a phase detector (PD) mode or a phase-frequency detector (PFD) mode for clock extraction. Further, the timing recovery lock detector circuit can detect successful clock acquisition in both oversampled and single-sample per symbol systems. Further, the timing recovery lock detector circuit serves as a loss of lock detector for detecting inappropriate timing recovery working after declared clock acquisition. Moreover, the timing recovery lock detector circuit does not depend on channel conditions, i.e., the lock detector is independent of ISI, noise, and other channel distortions.

In an implementation form, the subtraction operation is performed between two samples generated by the LD.

By virtue of using the subtraction operation, the negative impact of sampling phase variations, which are caused by various factors (such as sinusoidal jitter, clock offset variations, and random sampling phase variations like self-jitter), is eliminated.

In a further implementation form, the subtraction operation is performed between a sample generated by the LD and an origin sample generated by the timing recovery circuit at an origin point T=0.

Beneficially, the receiver clock signal is reliably synchronized with the transmission clock signal.

In a further implementation form, the ADC is configured to process a plurality of symbols in parallel, and wherein the subtraction operation is performed between two averaged samples, generated by sampling each symbol at a common sampling point and averaging the result.

Beneficially, the negative impact of sampling phase variations caused by sinusoidal jitter, clock offset variations, and random sampling phase variations (e.g., self-jitter) is eliminated. In a further implementation form, an order of the subtraction operation is based on the time order of the respective sampling points.

According to the invention, the earlier sample is subtracted from the later sample so as to ensure that the result of subtraction operation is positive. Thus, the clock of the signal receiver apparatus gets successfully synchronized with the clock of the signal transmitter apparatus.

In a further implementation form, the output signal is configured to activate one or more modules of the signal receiver apparatus.

Beneficially, the equaliser is activated and the inter symbol interference (ISI) for recovery of the transmit symbols is reduced.

In a further implementation form, the reset threshold value is one.

Beneficially, the timing recovery lock detector circuit serves as a loss of lock detector for detecting inappropriate timing recovery working after declared clock acquisition.

In a further implementation form, the lock detector circuit is further configured to determine, if the timing lock counter is reset, that the timing recovery circuit is unlocked, and to output an unlocked signal in response to determining that the timing recovery circuit has changed from locked to unlocked.

Beneficially, the unlocked state of the timing recovery lock detector circuit can be detected successfully.

In a further implementation form, the lock detector circuit comprises a phase detection filter, PDFIL, and, optionally, a resampling block, RES, configured to generate the at least one sample.

Beneficially, the timing recovery lock detector circuit becomes independent of channel conditions (e.g., ISI, noise, and other channel distortions) and can detect successful clock acquisition in both oversampled and single-sample per symbol systems.

In another aspect, the present disclosure provides a signal receiver apparatus. The signal receiver apparatus comprises at least one analog-to-digital convertor (ADC) configured to quantize a received signal based on a receiver clock signal; a timing recovery (TR) circuit configured to generate a timing signal to synchronise the receiver clock signal with a transmission clock signal of the received signal; and the lock detector circuit of the aforementioned aspect.

The signal receiver apparatus of the present disclosure generates two samples and compute their difference to provide information about the timing recovery status, i.e., whether the timing recovery circuit is locked or unlocked (loss of lock). The signal receiver apparatus is applicable for coherent as well as non-coherent systems by using either a phase detector (PD) mode or a phase-frequency detector (PFD) mode for clock extraction. Further, the signal receiver apparatus can detect successful clock acquisition in both oversampled and single-sample per symbol systems. Further, the signal receiver apparatus serves as a loss of lock detector for detecting inappropriate timing recovery working after declared clock acquisition. Moreover, the signal receiver apparatus does not depend on channel conditions, i.e., the lock detector is independent of ISI, noise, and other channel distortions.

In an implementation form, the timing recovery circuit comprises a phase detection filter (PDFIL), and, optionally, a resampling block (RES) configured to generate an origin sample at an origin point T=0 of the quantised signal.

By virtue of the phase detection filter, the signal receiver apparatus becomes independent of channel conditions (e.g., ISI, noise, and other channel distortions). By virtue of the resampling block, the signal receiver apparatus can detect successful clock acquisition in both oversampled and single-sample per symbol systems.

In a further implementation form, the signal receiver apparatus further comprises a phase detector (PD) configured to generate timing information based the origin sample to indicate whether the receiver clock signal is faster or slower that the transmission clock signal.

By virtue of the phase detector, the signal receiver apparatus can detect the phase deviations in the clock signal.

In a further implementation form, the lock detector circuit is configured to generate timing information based at least two generated samples to indicate whether the receiver clock signal is faster or slower that the transmission clock signal.

Beneficially, the timing information about the timing recovery status, i.e., whether the timing recovery circuit is locked or unlocked (loss of lock) can be indicated.

In a further implementation form, the signal receiver apparatus further comprises a voltage-controlled oscillator (VCO) configured to generate the timing signal based on the timing information.

Beneficially, the receiver clock signal can be generated according the timing information.

In a further implementation form, the signal receiver apparatus further comprises an equaliser, configured to activate in response to the output signal from the lock detector circuit.

Beneficially, the inter symbol interference (ISI) for recovery of the transmit symbols is reduced.

In a yet another aspect, the present disclosure provides a method of detecting a timing recovery lock in a signal receiver apparatus. The method comprises receiving a quantised signal from an analog-to-digital convertor (ADC) of the signal receiver apparatus, the quantised signal having a periodic unit interval UI; generating at least one sample at a sampling point in the range of T= -0.25 UI to T= +0.25 UI of the quantised signal; performing a subtraction operation between two samples generated from the quantised signal; incrementing a timing lock counter if a result of the subtraction operation is positive; increment a reset counter if the result of the subtraction operation is negative, and reset the timing lock counter if the reset counter is above a reset threshold value; determining, if the timing lock counter is above a threshold value, that a timing recovery circuit of the signal receiver apparatus is locked; and generating an output signal in response to determining that the timing recovery circuit is locked.

The method executed by the timing recovery lock detector circuit achieves all the advantages and effects of the timing recovery lock detector circuit of the present disclosure.

In an implementation form, the subtraction operation is performed between two samples generated by a lock detection circuit of the signal receiver apparatus.

By virtue of using the subtraction operation, the negative impact of sampling phase variations, which are caused by various factors (such as sinusoidal jitter, clock offset variations, and random sampling phase variations like self-jitter), is eliminated.

In a further implementation form, the subtraction operation is performed between a sample generated by a lock detection circuit of the signal receiver apparatus and an origin sample generated by the timing recovery circuit at an origin point T=0.

Beneficially, the receiver clock signal is reliably synchronized with the transmission clock signal.

In a further implementation form, the ADC is configured to process a plurality of symbols in parallel, and wherein the subtraction operation is performed between two averaged samples, generated by sampling each symbol at a common sampling point and averaging the result.

Beneficially, the negative impact of sampling phase variations caused by sinusoidal jitter, clock offset variations, and random sampling phase variations (e.g., self-jitter) is eliminated. In a further implementation form, an order of the subtraction operation is based on the time order of the respective sampling points.

According to the invention, the earlier sample is subtracted from the later sample so as to ensure that the result of subtraction operation is positive. Thus, the clock of the signal receiver apparatus gets successfully synchronized with the clock of the signal transmitter apparatus.

In a further implementation form, the output signal is configured to activate one or more modules of the signal receiver apparatus.

Beneficially, the equaliser is activated and the inter symbol interference (ISI) for recovery of the transmit symbols is reduced.

In a further implementation form, the reset threshold value is one.

Beneficially, the unlocked state of the timing recovery lock detector circuit can be detected successfully.

In a further implementation form, the method further comprises determining, if the timing lock counter is reset, that the timing recovery circuit is unlocked, and outputting an unlocked signal in response to determining that the timing recovery circuit has changed from locked to unlocked.

Beneficially, the method becomes independent of channel conditions (e.g., ISI, noise, and other channel distortions) and can detect successful clock acquisition in both oversampled and single-sample per symbol systems.

It has to be noted that all devices, elements, circuitry, units and means described in the present application could be implemented in the software or hardware elements or any kind of combination thereof. All steps which are performed by the various entities described in the present application as well as the functionalities described to be performed by the various entities are intended to mean that the respective entity is adapted to or configured to perform the respective steps and functionalities. Even if, in the following description of specific embodiments, a specific functionality or step to be performed by external entities is not reflected in the description of a specific detailed element of that entity which performs that specific step or functionality, it should be clear for a skilled person that these methods and functionalities can be implemented in respective software or hardware elements, or any kind of combination thereof. It will be appreciated that features of the present disclosure are susceptible to being combined in various combinations without departing from the scope of the present disclosure as defined by the appended claims.

Additional aspects, advantages, features and objects of the present disclosure would be made apparent from the drawings and the detailed description of the illustrative implementations construed in conjunction with the appended claims that follow.

BRIEF DESCRIPTION OF THE DRAWINGS

The summary above, as well as the following detailed description of illustrative embodiments, is better understood when read in conjunction with the appended drawings. For the purpose of illustrating the present disclosure, exemplary constructions of the disclosure are shown in the drawings. However, the present disclosure is not limited to specific methods and instrumentalities disclosed herein. Moreover, those in the art will understand that the drawings are not to scale. Wherever possible, like elements have been indicated by identical numbers.

Embodiments of the present disclosure will now be described, by way of example only, with reference to the following diagrams wherein:

FIG. 1                is a schematic diagram of a timing recovery lock detector circuit, in accordance with an embodiment of the present disclosure;

FIG. 2                is a schematic diagram of a timing recovery lock detector circuit, in accordance with another embodiment of the present disclosure;

FIG. 3                is a schematic diagram of a timing recovery lock detector circuit, in accordance with yet another embodiment of the present disclosure;

FIG. 4                is a schematic diagram of a timing recovery lock detector circuit, in accordance with yet another embodiment of the present disclosure;

FIG. 5                is a schematic diagram of a timing recovery lock detector circuit, in accordance with yet another embodiment of the present disclosure;

FIG. 6                is a schematic diagram of a timing recovery lock detector circuit, in accordance with yet another embodiment of the present disclosure;

FIG. 7                is a block diagram of a signal receiver apparatus, in accordance with an embodiment of the present disclosure;

FIG. 8A and FIG. 8B    collectively, is a flowchart of a method of detecting a timing recovery lock in a signal receiver apparatus, in accordance with an embodiment of the present disclosure;

FIG. 9                is a schematic diagram of a lock detector logic block, in accordance with an embodiment of the present disclosure;

FIG. 10A               is a graphical representation that depicts a phase detector filter and phase detector filter taps, in accordance with an embodiment of the present disclosure;

FIG. 10B               is a graphical representation that depicts a timing error detector characteristic curve for a phase detector filter, in accordance with an embodiment of the present disclosure;

FIG. 11A               is a graphical representation that depicts an estimated clock offset during acquisition, in accordance with an embodiment of the present disclosure;

FIG. 11B is a graphical representation that depicts lock detector signal, in accordance with an embodiment of the present disclosure;

FIG. 12A is a graphical representation that depicts an estimated clock offset during acquisition, in accordance with another embodiment of the present disclosure;

FIG. 12B is a graphical representation that depicts lock detector signal, in accordance with another embodiment of the present disclosure;

FIG. 13A is a graphical representation that depicts an estimated clock offset during acquisition, in accordance with yet another embodiment of the present disclosure;

FIG. 13B is a graphical representation that depicts lock detector signal, in accordance with yet another embodiment of the present disclosure;

FIG. 14A is a graphical representation that depicts timing recovery and input phases, in accordance with yet another embodiment of the present disclosure;

FIG. 14B is a graphical representation that depicts an estimated clock offset during acquisition, in accordance with yet another embodiment of the present disclosure;

FIG. 14C is a graphical representation that depicts lock detector signal, in accordance with yet another embodiment of the present disclosure;

In the accompanying drawings, an underlined number is employed to represent an item over which the underlined number is positioned or an item to which the underlined number is adjacent. A non-underlined number relates to an item identified by a line linking the non-underlined number to the item. When a number is non-underlined and accompanied by an associated arrow, the non-underlined number is used to identify a general item at which the arrow is pointing.

DETAILED DESCRIPTION OF EMBODIMENTS

The following detailed description illustrates embodiments of the present disclosure and ways in which they can be implemented. Although some modes of carrying out the present disclosure have been disclosed, those skilled in the art would recognize that other embodiments for carrying out or practicing the present disclosure are also possible.

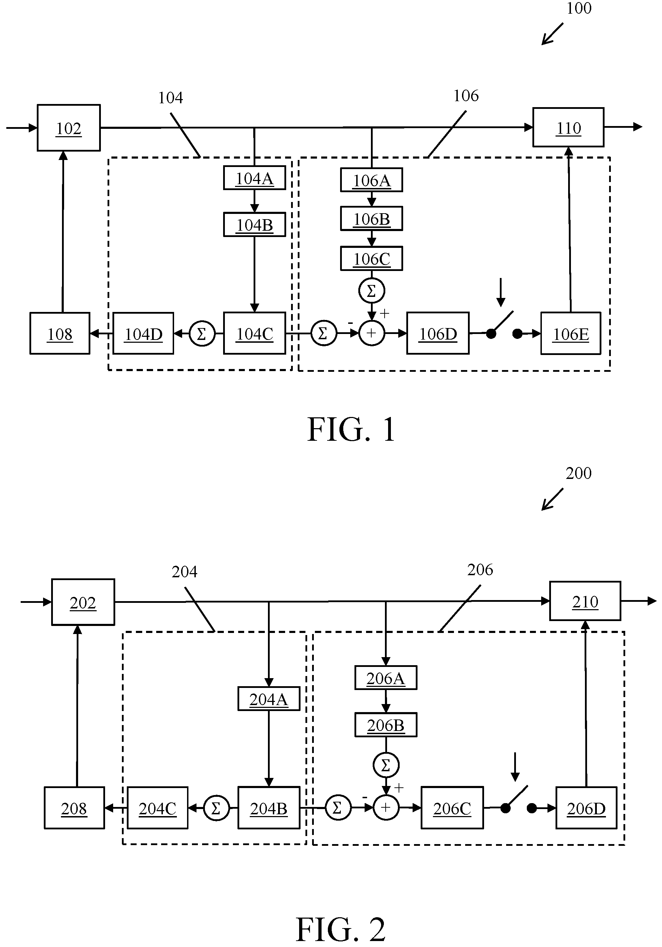

FIG. 1 is a schematic diagram of a timing recovery lock detector circuit, in accordance with an embodiment of the present disclosure. With reference to FIG. 1, there is shown a timing recovery lock detector circuit **100** that includes an analog-to-digital-converter **102**, a timing recovery circuit **104**, a lock detector circuit **106**, a voltage-controlled oscillator **108**, and an equaliser **110**. The timing recovery circuit **104** and the lock detector circuit **106** are represented by dashed boxes (the dashed boxes are used for illustration purpose only). The timing recovery circuit **104** further includes a first resampling block **104A**, a phase detector filter **104B**, a phase detector **104C**, and timing recovery filter **104D**. The lock detector circuit **106** further includes a second resampling block **106A**, a phase detector filter **106B**, a phase detector **106C**, an infinite impulse response filter **106D**, and a lock detector logic block **106E.**

The timing recovery lock detector circuit **100** refers to a clock recovery circuit or simply a lock detector (LD) circuit used for the synchronisation of digital signals. In many digital systems, data is transmitted or retrieved without any additional timing reference. For example, in optical communications, a stream of data flows over a single fiber with no accompanying clock, but the receiver is required to process this data synchronously. Therefore, the clock or timing information must be recovered from the data at the receiver. Clock extraction is the process of extracting timing information from a data stream to allow the receiving circuit to decode the transmitted symbols. Further, the clock extraction can be done in both phase detector (PD) mode and phase-frequency detector (PFD) mode. The timing recovery lock detector circuit **100** uses PD mode. Moreover, the timing recovery lock detector circuit **100** is designed for use in oversampled systems. The oversampled systems refer to the digital systems which employ oversampling process. The oversampling process refers to the process of sampling a signal at a sampling frequency significantly higher than the Nyquist rate. Theoretically, a bandwidth-limited signal can be perfectly reconstructed if sampled at the Nyquist rate or above it. The Nyquist rate is defined as twice the bandwidth of the signal. A signal is said to be oversampled by a factor of N if it is sampled at N times the Nyquist rate. Further, the oversampling process is capable of improving resolution and signal-to-noise ratio, and can be helpful in avoiding aliasing and phase distortion by relaxing anti-aliasing filter performance requirements. The timing recovery lock detector circuit **100** is a common component of systems communicating over wires, optical fibers, or by radio. Application areas of the timing recovery lock detector circuit **100** include, but are not limited to, telecommunications, optical transceivers, data and storage area networks, and wireless products.

In operation, the timing recovery lock detector circuit **100** is configured to receive a quantised signal from an analog-to-digital convertor **102** (ADC) of the signal receiver apparatus, the quantised signal having a periodic unit interval (UI). The analog-to-digital convertor **102** (ADC) refers to a system that converts an analog signal, such as a sound picked up by a microphone or light entering a digital camera, into a digital signal. Alternatively stated, the analog-to-digital convertor **102** refers to an electronic device that converts an input analog voltage or current to a digital number representing the magnitude of the voltage or current. Thus, the analog-to-digital convertor **102** quantises the signal received by the signal receiver apparatus from a signal transmitter apparatus. The input to the analog-to-digital convertor **102** is represented by an input signal 'r'. The output of the analog-to-digital convertor **102** is represented by a quantized signal 'x'. The quantized signal 'x' has a periodic unit interval. In general, the quantized signal 'x' can be complex and multidimensional. For example, in coherent optical systems, four ADCs are used to quantize complex signals from two polarizations. To save power, the ADC may provide samples at a baud rate. For simplicity, the analog-to-digital convertor **102** is assumed to be real and one-dimensional (i.e., a single ADC is used). Examples of analog-to-digital convertor **102** include, but are not limited to, direct-conversion or flash ADC, successive-approximation ADC, ramp-compare ADC, integrating ADC, delta-encoded or counter-ramp ADC, pipelined ADC, sigma-delta ADC, and many more.

The timing recovery lock detector circuit **100** is further configured to generate at least one sample at a sampling point in the range of T= -0.25 UI to T= +0.25 UI of the quantised signal. In high-speed systems, 'N' symbols are processed in parallel during one application-specific integrated circuit (ASIC) clock and several ADCs can be used to quantize the input signal 'r'. The analog-to-digital convertor **102** provides 1.h samples/symbols, where h≥0 for an oversampled signal. The first resampling block **104A** and the second resampling block **106A** are interpolators used to generate samples at specific time instants when h>0. The first resampling block **104A** and the second resampling block **106A** are often realized as finite impulse response filters (FIR). The first resampling block **104A** and the phase detector filter **104B** can also be designed as a single FIR filter. Similarly, the second resampling block **106A** and the phase detector filter **106B** can also be designed as a single FIR filter. The phase detector filter **106B** is similar to the phase detector filter **104B**. The phase detector filter **104B** and the phase detector filter **106B** may or may not be used that depends on channel impairments. The timing recovery lock detector circuit **100** generates a timing error detector characteristic (TEDC) curve, i.e., an error signal based on the synchronization estimate between the transmitting clock and the receiving clock. The timing recovery circuit **104** provides a first sample at a sampling point (SP), i.e., TEDC(SP), at zero-time unit interval (T= 0 UI), which is generated by the first resampling block **104A**. The lock detector circuit **106** provides a second sample generated by the second resampling block **106A** at any one of the two sampling points, i.e., first lock detector sampling phase (TEDC(LDSP1)) and second lock detector sampling phase (TEDC(LDSP2)), in the range of T= -0.25 UI to T= +0.25 UI such that TEDC(LDSP2)>TEDC(SP) >TEDC(LDSP1). The second sample may also be referred to as a control signal. In other words, the phase '$\tau_1$' is the timing recovery circuit **104** sampling phase that is 0 while the lock detector circuit **106** sampling phase '$\tau_2$' is such that $0 < \tau_2 \leq UI/4$. The phase '$\tau_1$' is detected by the phase detector **104C** and the phase "$\tau_2$" is detected by the phase detector **106C.** Further, the lock detector circuit **106** uses 'K' symbols (K≤N) to detect the locking stage (locked or unlocked). The timing recovery filter **104D** is used to filter out the timing information provided by the phase detector **104C** because the timing information is noisy as it suffers from pattern-dependent noise, noise caused by amplifiers, component imperfections, etc. The filtered timing information is fed to the voltage-controlled oscillator **108**. Hence, the timing recovery lock detector circuit **100** uses TEDC values at two sampling points to detect lock. Since one sample (TEDC(SP)) is already generated by the timing recovery circuit **104**, the timing recovery lock detector circuit **100** is configured to generate at least one sample with the help of the lock detector circuit **106**.

In accordance with an embodiment, the lock detector circuit **106** comprises a phase detection filter **106B**, PDFIL, and, optionally, a resampling block, RES, configured to generate the at least one sample. The lock detector circuit **106** comprises the phase detection filter **106B** to improve clock extraction under bad channel conditions, i.e., where inter-symbol interference (ISI) is a serious issue. Hence, the phase detection filter **106B** may or may not be used that depends on channel impairments. Further, the lock detector circuit **106** comprises the second resampling block **106A**. The second resampling block **106A** refers to an interpolator used to generate samples at specific time instants in oversampled systems. The second resampling block **106A** generates the second sample '$u_2$' in the range of T= -0.25 UI to T= +0.25 UI. The second resampling block **106A** is often realized as a finite impulse response filter (FIR). Moreover, the second resampling block **106A** and the phase detection filter **106B** can be designed as a single FIR filter.

The timing recovery lock detector circuit **100** is further configured to perform a subtraction operation between two samples generated from the quantised signal. The first sample generated by the timing recovery circuit **104** is termed as sample '$u_1$'. The second sample generated by the lock detector circuit **106** is termed as sample '$u_2$'. The timing recovery lock detector circuit **100** performs the subtraction operation between the two samples '$u_2$' and '$u_1$' such that $w=u_2-u_1$. The subtraction operation outputs information whether the sampling clock is faster or slower. The difference of the two samples 'w' is averaged by the infinite impulse response filter **106D**. The output of the infinite impulse response filter **106D** is termed as lock control signal 's', which is fed into the lock detector logic block **106E**.

In accordance with an embodiment, the subtraction operation is performed between two samples generated by the LD. The first sample 'u$_1$' is generated by the timing recovery circuit **104**. The second sample 'u$_2$' is generated by the lock detector circuit **106**. The timing recovery lock detector circuit **100** performs the subtraction operation between the two samples 'u$_2$' and 'u$_1$' such that w=u$_2$-u$_1$. The subtraction operation outputs information whether the sampling clock is faster or slower. By virtue of using 'u$_2$' and 'u$_1$' signals, the negative impact of sampling phase variations, which are caused by various factors (such as sinusoidal jitter, clock offset variations, and random sampling phase variations like self-jitter), is eliminated.

In accordance with an embodiment, the subtraction operation is performed between a sample generated by the LD and an origin sample generated by the timing recovery circuit **104** at an origin point T=0. The first sample 'u$_1$' is generated by the timing recovery circuit **104**. The timing recovery circuit **104** provides the first sample 'u$_1$' at a sampling point (SP), i.e., TEDC(SP), at zero time unit interval (T= 0 UI), which is generated by the first resampling block **104A**. Hence, the first sample 'u$_1$' generated by the timing recovery circuit **104** is also referred to as the origin sample. The second sample 'u$_2$' is generated by the lock detector circuit **106**. The lock detector circuit **106** provides the second sample 'u$_2$' generated by the second resampling block **106A** at any one of the two sampling points, i.e., first lock detector sampling phase (TEDC(LDSP1)) and second lock detector sampling phase (TEDC(LDSP2)), in the range of T= -0.25 UI to T= +0.25 UI such that TEDC(LDSP2)>TEDC(SP)>TEDC(LDSP1). Further, the timing recovery lock detector circuit **100** performs the subtraction operation between the two samples 'u$_2$' and 'u$_1$' such that w=u$_2$-u$_1$.

In accordance with an embodiment, the ADC is configured to process a plurality of symbols in parallel, and wherein the subtraction operation is performed between two averaged samples, generated by sampling each symbol at a common sampling point and averaging the result. In high-speed systems, 'N' symbols are processed in parallel during one application-specific integrated circuit (ASIC) clock and several ADCs can be used to quantize the input signal 'r'. Hence, a single analog-to-digital convertor **102** is configured to process the plurality of symbols in parallel to generate the quantized signal 'x', which is configured to be real and one-dimensional. Further, the timing recovery lock detector circuit **100** uses 'K' symbols (K≤N) to detect the timing recovery locking stage (locked or unlocked). The 'K' symbols are averaged to generate the samples at the common sampling point. Beneficially, the negative impact of sampling phase variations caused by sinusoidal jitter, clock offset variations, and random sampling phase variations (e.g., self-jitter) is eliminated.

In accordance with an embodiment, an order of the subtraction operation is based on the time order of the respective sampling points. The two samples 'u$_1$' and 'u$_2$' of the timing recovery lock detector circuit **100** are generated by the first resampling block **104A** of the timing recovery circuit **104** and the second resampling block **106A** of the lock detector circuit **106**, respectively. The order of the subtraction operation (i.e., u$_1$-u$_2$ or u$_2$-u$_1$) is selected such that the earlier sample is subtracted from the later sample so as to ensure that the result of subtraction operation is positive. When the result of subtraction operation is positive the timing lock counter is incremented by the lock detector logic block **106E**, which indicates that the lock is detected. Beneficially, the clock of the signal receiver apparatus is successfully synchronized with the clock of the signal transmitter apparatus.

The timing recovery lock detector circuit **100** is further configured to increment a timing lock counter if a result of the subtraction operation is positive. The ASIC frequency is f$_s$/N, where 'f$_s$' denotes a symbol frequency (rate). The parameter 'G' defines the checking frequency of the lock control signal 's'. The frequency f$_{ASIC}$/G is a clock frequency of all the blocks in the lock detector circuit **106** after the infinite impulse response filter **106D**. To ensure a proper lock detector working, the lock control signal 's' is multiplied by sign($\tau_j$-$\tau_{j-1}$) to generate the signal 's$_0$'. A parameter 'p$_1$' defines the first lock detection threshold. The parameter 'p$_1$' can be set to 0, however, other values larger than 0 can also be selected. The parameter 'p$_1$' is added to the signal 's$_0$' to generate the signal 's$_1$'. The sign of the difference s$_1$-s$_0$ ($\pm$1) is fed into the timing lock counter, which is limited by a parameter 'p$_2$' (i.e., maximum value is p$_2$). Thus, the timing lock counter increases a value by 1 when s$_2$=1 (i.e., if the result of the subtraction operation is positive).

The timing recovery lock detector circuit **100** is further configured to increment a reset counter if the result of the subtraction operation is negative and reset the timing lock counter if the reset counter is above a reset threshold value. To ensure a proper lock detector working, the lock control signal 's' is multiplied by sign($\tau_j$-$\tau_{j-1}$) to generate the signal 's$_0$'. A parameter 'p$_1$' defines the first lock detection threshold. The parameter 'p$_1$' can be set to 0, however, other values larger than 0 can also be selected. The parameter 'p$_1$' is added to the signal 's$_0$' to generate the signal 's$_1$'. The sign of the difference s$_1$-s$_0$ ($\pm$1) is fed into the timing lock counter, which is limited by a parameter 'p$_2$' (i.e., maximum value is p$_2$). Thus, the reset counter increases a value by 1 when s$_2$=-1 (i.e., if the result of the subtraction operation is negative). Also, the timing lock counter is reset to 0 if the reset counter is above the reset threshold value.

In accordance with an embodiment, the reset threshold value is one. The reset threshold value is used to detect the loss of lock/clock caused by some disturbances and to activate the timing recovery re-acquisition process. When the result of the subtraction operation between the two samples 'u$_1$' and 'u$_2$' is negative, the reset counter is incremented by one and the timing lock counter is reset to zero. Thus, to efficiently detect the loss of lock/clock, the reset threshold value is set to one so that as soon as the reset counter reaches one, the lock detector logic block **106E** declares the timing recovery circuit **104** to be in unlocked state.

The timing recovery lock detector circuit **100** is further configured to determine, if the timing lock counter is above a lock threshold value, that a timing recovery circuit **104** of the signal receiver apparatus is locked. The timing lock counter increases a value by 1 when $s_2$=1 and when the old value '$s_3$' is $s_3$<$p_2$. However, when $s_2$=-1 the timing lock counter is reset to 0.

When the timing lock counter value $s_3$ is $s_3$≥$p_3$, where '$p_3$' is the lock threshold value, the signal $s_4$ becomes $s_4$≥0. Thus, the timing recovery circuit **104** is locked otherwise it is unlocked. The parameters '$p_3$' can be set to '$p_2$' and the locking is indicated when $s_4$=0.

In accordance with an embodiment, the lock detector circuit **106** is further configured to determine, if the timing lock counter is reset, that the timing recovery circuit **104** is unlocked, and to output an unlocked signal in response to determining that the timing recovery circuit **104** has changed from locked to unlocked. When the result of the subtraction operation between the two samples '$u_1$' and '$u_2$' is negative, the reset counter is incremented by one and the timing lock counter is reset to zero. Since the reset threshold value is set to one, the lock detector logic block **106E** declares the timing recovery circuit **104** to be in unlocked state when the reset counter reaches the value one. Thus, the output signal of the lock detector logic block **106E** determines that the timing recovery circuit **104** has changed from locked state to unlocked state and the timing recovery re-acquisition process is activated.

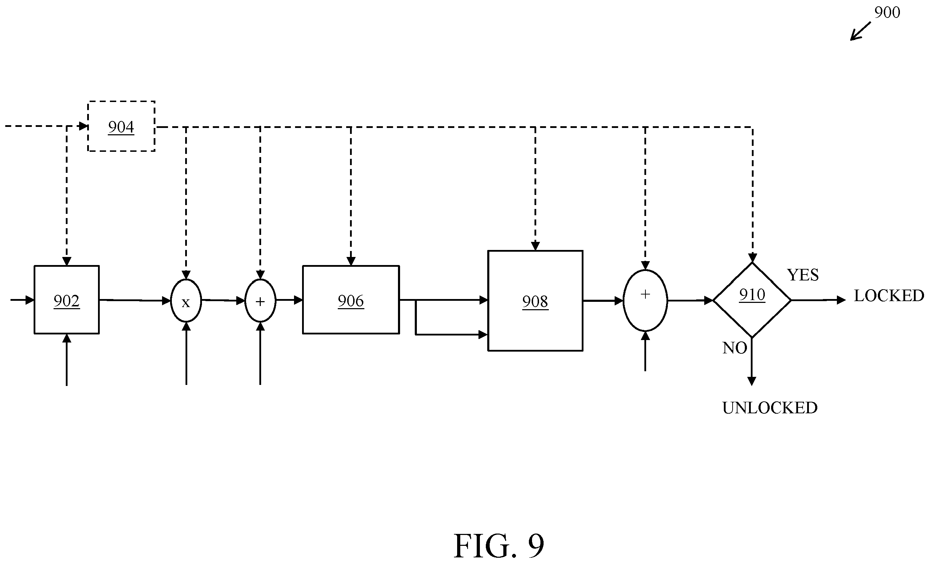

The timing recovery lock detector circuit **100** is further configured to generate an output signal in response to determining that the timing recovery circuit **104** is locked. The lock detector logic block **106E** generates the output signal, which indicates the timing recovery status (i.e., whether the timing recovery circuit **104** is locked or unlocked (loss of lock)). The output signal is fed to the equaliser **110**. Thus, the lock detector logic block **106E** announces acquisition if specific conditions are fulfilled and opens the equaliser **110**. On the other hand, after sometime the lock detector logic block **106E** can detect loss of lock/clock caused by some disturbances and activate the timing recovery re-acquisition process. The lock detector logic block **106E** is described in detail in FIG. 9.

In accordance with an embodiment, the output signal is configured to activate one or more modules of the signal receiver apparatus. The output signal is generated by the lock detector logic block **106E**, which provides information about the timing recovery status, i.e., whether the timing recovery circuit **104** is locked or unlocked (loss of lock). The output signal is fed to the equaliser **110**. Thus, the lock detector logic block **106E** announces acquisition if specific conditions are fulfilled and activates one or more modules of the signal receiver apparatus, such as the equaliser **110**. On the other hand, after sometime the lock detector logic block **106E** can detect loss of lock/clock caused by some disturbances and activates the timing recovery re-acquisition process. Hence, the output signal of the lock detector logic block **106E** is fed to the equaliser **110** to activate the equaliser **110** to reduce inter symbol interference (ISI) for recovery of the transmit symbols.

Thus, the timing recovery lock detector circuit **100** uses phase detector mode for clock extraction and is applicable for oversampled systems. The timing recovery lock detector circuit **100** generates two samples '$u_1$' and '$u_2$', where the first sample is generated by the first resampling block **104A** of the timing recovery circuit **104** and the second sample is generated by the second resampling block **106A** of the lock detector circuit **106**. The first resampling block **104A** generates the first sample (or the origin sample) at the origin point T=0. The second resampling block **106A** generates the second sample in the range of T = - 0.25 UI to T = +0.25 UI. The subtraction operation is performed between the two samples. If the result of the subtraction operation is positive, timing lock counter is incremented. If the result of the subtraction operation is negative, reset counter is incremented and the timing lock counter is reset if the reset counter is above the reset threshold value, which is set to one. Hence, the lock detector logic block **106E** determines that the timing recovery circuit **104** is in locked state if the timing lock counter is set. On the other hand, the lock detector logic block **106E** determines that the timing recovery circuit **104** is in unlocked state if the timing lock counter is reset, and activates the timing recovery re-acquisition process.

FIG. 2 is a schematic diagram of a timing recovery lock detector circuit, in accordance with another embodiment of the present disclosure. FIG. 2 is described in conjunction with elements from FIG. 1. With reference to FIG. 2, there is shown a timing recovery lock detector circuit **200** that includes an analog-to-digital-converter **202**, a timing recovery circuit **204**, a lock detector circuit **206**, a voltage-controlled oscillator **208**, and an equaliser **210**. The timing recovery circuit **204** and the lock detector circuit **206** are represented by dashed boxes (the dashed boxes are used for illustration purpose only). The timing recovery circuit **204** further includes a phase detector filter **204A**, a phase detector **204B**, and timing recovery filter **204C**. The lock detector circuit **206** further includes a first phase detector filter **206A**, a phase detector **206B**, an infinite impulse response filter **206C**, and a lock detector logic block **206D**.

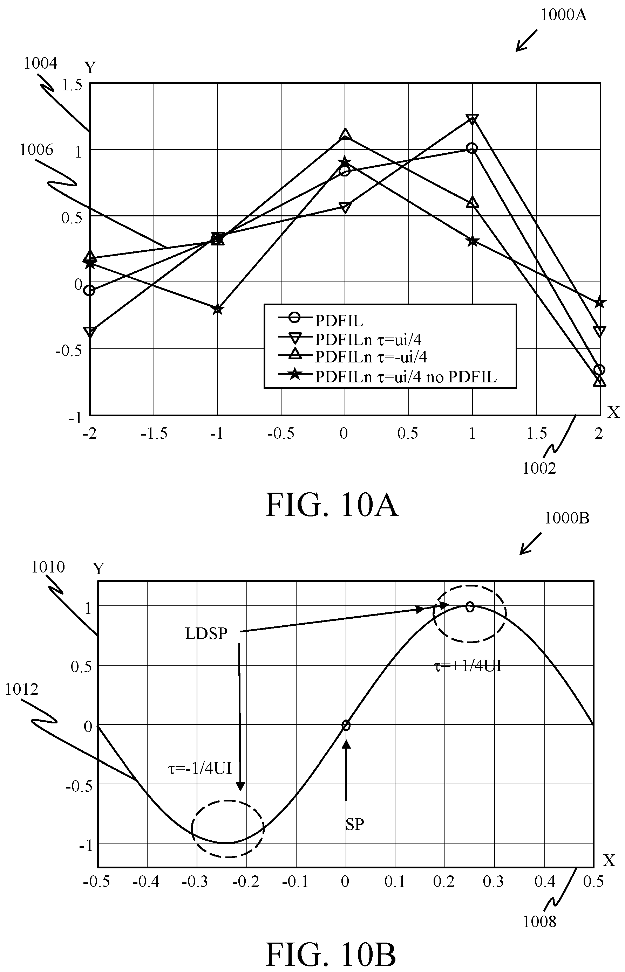

The timing recovery lock detector circuit **200** corresponds to the timing recovery lock detector circuit **100** (of FIG. 1) except that the timing recovery lock detector circuit **200** uses a single sample per symbols (i.e., 1 sps) analog-to-digital convertor **202**. Hence, the timing recovery lock detector circuit **200** is applicable for one sample per symbol systems. Further, the resampling blocks are not used in the timing recovery lock detector circuit **200**. Further, the phase detector filter **204A** of the timing recovery circuit **204** and the first phase detector filter **206A** of the lock detector circuit **206** are different from each other, which are discussed in detail in FIG. 10A and 10B. The timing recovery lock detector circuit **200** is a first alternative implementation of the timing recovery lock detector circuit **100** (of FIG. 1).

The working and connections of the analog-to-digital-converter **202**, the timing recovery circuit **204**, the phase detector filter **204A**, the phase detector **204B**, the timing recovery filter **204C**, the lock detector circuit **206**, the phase detector **206B**, the infinite impulse response filter **206C**, the lock detector logic block **206D**, the voltage-controlled oscillator **208**, and the equaliser **210**, of the timing recovery lock detector circuit **200** is same that has been described in detail, for example, in FIG. 1 and hence, omitted here for the sake of brevity.

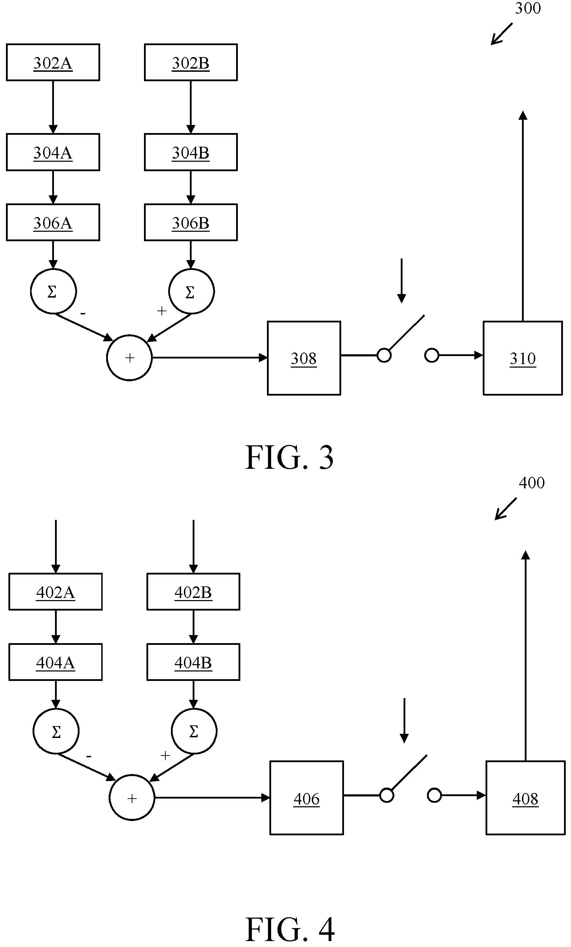

FIG. 3 is a schematic diagram of a timing recovery lock detector circuit, in accordance with yet another embodiment of the present disclosure. FIG. 3 is described in conjunction with elements from FIG. 1 and FIG. 2. With reference to FIG. 3, there is shown a timing recovery lock detector circuit **300** that includes a second resampling block **302A**, a third resampling block **302B**, a phase detector filter **304A**, a phase detector filter **304B**, a phase detector **306A**, a phase detector **306B**, an infinite impulse response filter **308**, and a lock detector logic block **310**. The timing recovery lock detector circuit **300** shows only the lock detector circuit corresponding to the lock detector circuit **106** of the timing recovery lock detector circuit **100** (of FIG. 1).

The timing recovery lock detector circuit **300** corresponds to the timing recovery lock detector circuit **100** (of FIG. 1) except that the timing recovery lock detector circuit 300 generates the control signals in a different way. The phases after the phase detector **306A** and the phase detector **306B** are '$\tau_2$' and '$\tau_3$', respectively, where $-UI/4 \leq \tau_2 < 0 < \tau_3 \leq UI/4$ and the timing recovery circuit samples at phase $\tau_1 = 0$. The timing recovery lock detector circuit **300** is a second alternative implementation of the timing recovery lock detector circuit **100** (of FIG. 1).

The working and connections of the second resampling block **302A**, the third resampling block **302B**, the phase detector filter **304A**, the phase detector filter **304B**, the phase detector **306A**, the phase detector **306B**, the infinite impulse response filter **308**, and the lock detector logic block **310**, of the timing recovery lock detector circuit **300** is same that has been described in detail, for example, in FIG. 1 and hence, omitted here for the sake of brevity.

FIG. 4 is a schematic diagram of a timing recovery lock detector circuit, in accordance with yet another embodiment of the present disclosure. FIG. 4 is described in conjunction with elements from FIGs. 1, 2, and 3. With reference to FIG. 4, there is shown a timing recovery lock detector circuit **400** that includes a first phase detector filter **402A**, a second phase detector filter **402B**, a phase detector **404A**, a phase detector **404B**, an infinite impulse response filter **406**, and a lock detector logic block **408**. The timing recovery lock detector circuit **400** shows only the lock detector circuit corresponding to the lock detector circuit **106** of the timing recovery lock detector circuit **100** (of FIG. 1).

The timing recovery lock detector circuit **400** corresponds to the timing recovery lock detector circuit **100** (of FIG. 1) except that the timing recovery lock detector circuit **400** uses a single sample per symbols (i.e., 1 sps) ADC. Hence, the timing recovery lock detector circuit **400** is applicable for one sample per symbol systems. Further, the resampling blocks are not used in the timing recovery lock detector circuit **400**. Further, the first phase detector filter **402A** and the second phase detector filter **402B** are different from each other, which are discussed in detail in FIG. 10A and 10B. The timing recovery lock detector circuit **400** generates the control signals in a different way. The phases after the phase detector **404A** and the phase detector **404B** are '$\tau_2$' and '$\tau_3$', respectively, where $-UI/4 \leq \tau_2 < 0 < \tau_3 \leq UI/4$ and the timing recovery circuit samples at phase $\tau_1 = 0$. The timing recovery lock detector circuit **400** is a third alternative implementation of the timing recovery lock detector circuit **100** (of FIG. 1).

The working and connections of the first phase detector filter **402A**, the phase detector **404A**, the phase detector **404B**, the infinite impulse response filter **406**, and the lock detector logic block **408**, of the timing recovery lock detector circuit **400** is same that has been described in detail, for example, in FIG. 1 and hence, omitted here for the sake of brevity.

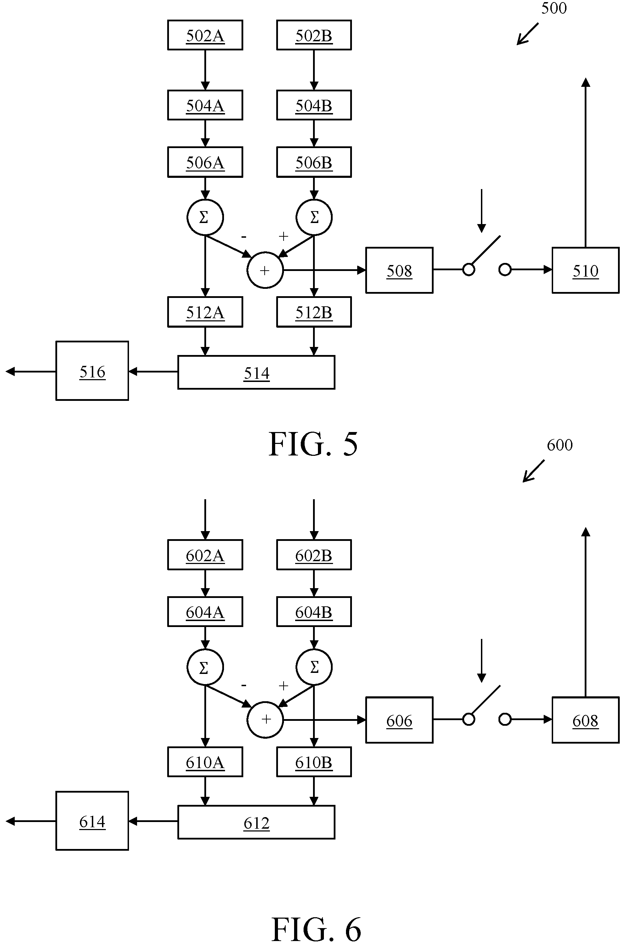

FIG. 5 is a schematic diagram of a timing recovery lock detector circuit, in accordance with yet another embodiment of the present disclosure. FIG. 5 is described in conjunction with elements from FIGs. 1, 2, 3, and 4. With reference to FIG. 5, there is shown a timing recovery lock detector circuit **500** that includes a first resampling block **502A**, a second resampling block **502B**, a phase detector filter **504A**, a phase detector filter **504B**, a phase detector **506A**, a phase detector **506B**, an infinite impulse response filter **508**, a lock detector logic block **510**, a first infinite impulse response filter **512A**, a first infinite impulse response filter **512B**, an arc tan block **514**, and a timing recovery filter **516**. The timing recovery lock detector circuit **500** shows only the lock detector circuit corresponding to the lock detector circuit **106** of the timing recovery lock detector circuit **100** (of FIG. 1).

The timing recovery lock detector circuit **500** corresponds to the timing recovery lock detector circuit **100** (of FIG. 1) except that the timing recovery lock detector circuit 500 uses phase-frequency detector mode for clock extraction. The timing recovery lock detector circuit **500** uses in-phase with the first resampling block **502A** and quadrature-phase with the second resampling block **502B**. The samples 'u1' and 'u2' are averaged by filters denoted by the first infinite impulse response filter **512A** and the first infinite impulse response filter **512B.** The averaged sample outputs are fed into the arc tan block **514**. The arc tan block **514** includes the arctangent and/or unwrapping function (ATAN/UNWRAP). The arctangent function is also referred to as the inverse tangent function. The arctangent function accepts any number and returns the angle from the range -pi/2 through +pi/2 radians that has that tangent. The timing recovery lock detector circuit **500** is a fourth alternative implementation of the timing recovery lock detector circuit **100** (of FIG. 1).

The working and connections of the first resampling block **502A**, the second resampling block **502B**, the phase detector filter **504A**, the phase detector filter **504B**, the phase detector **506A**, the phase detector **506B**, the infinite impulse response filter 508, the lock detector logic block **510**, the first infinite impulse response filter **512A**, the first infinite impulse response filter **512B**, and the timing recovery filter **516**, of the timing recovery lock detector circuit **500** is same that has been described in detail, for example, in FIG. 1 and hence, omitted here for the sake of brevity.

FIG. 6 is a schematic diagram of a timing recovery lock detector circuit, in accordance with yet another embodiment of the present disclosure. FIG. 6 is described in conjunction with elements from FIGs. 1, 2, 3, 4, and 5. With reference to FIG. 6, there is shown a timing recovery lock detector circuit **600** that includes a first phase detector filter **602A**, a second phase detector filter **602B**, a phase detector **604A**, a phase detector **604B**, an infinite impulse response filter **606**, a lock detector logic block **608**, a first infinite impulse response filter **610A**, a first infinite impulse response filter **610B**, an arc tan block **612**, and a timing recovery filter **614**. The timing recovery lock detector circuit **600** shows only the lock detector circuit corresponding to the lock detector circuit **106** of the timing recovery lock detector circuit **100** (of FIG. 1).

The timing recovery lock detector circuit **600** corresponds to the timing recovery lock detector circuit **100** (of FIG. 1) except that the timing recovery lock detector circuit **600** uses phase-frequency detector mode for clock extraction and is applicable for one sample per symbols systems. Further, the resampling blocks are not used in the timing recovery lock detector circuit **600**. The timing recovery lock detector circuit **600** uses in-phase with the first phase detector filter **602A** and quadrature-phase with the second phase detector filter **602B**. Further, the first phase detector filter **602A** and the second phase detector filter **602B** are different from each other, which are discussed in detail in FIG. 10A and 10B. The timing recovery lock detector circuit **600** is a fifth alternative implementation of the timing recovery lock detector circuit **100** (of FIG. 1).

The working and connections of the first phase detector filter **602A**, the second phase detector filter **602B**, the phase detector **604A**, the phase detector **604B**, the infinite impulse response filter **606**, the lock detector logic block **608**, the first infinite impulse response filter **610A**, the first infinite impulse response filter **610B**, and the timing recovery filter **614**, of the timing recovery lock detector circuit **600** is same that has been described in detail, for example, in FIG. 1 and hence, omitted here for the sake of brevity

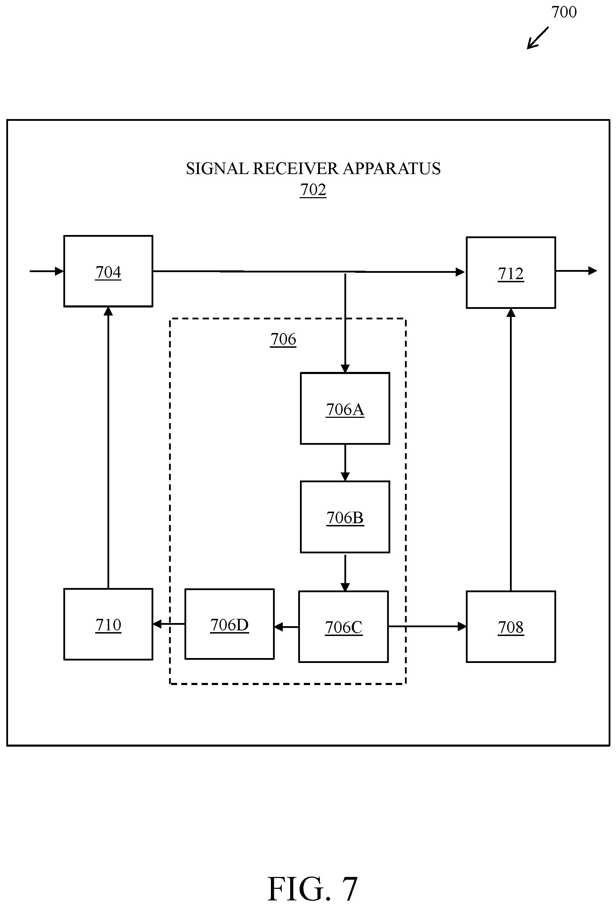

FIG. 7 is a block diagram of a signal receiver apparatus, in accordance with an embodiment of the present disclosure. FIG. 7 is described in conjunction with elements from FIGs. 1, 2, 3, 4, 5, and 6. With reference to FIG. 7, there is shown a block diagram **700** of a signal receiver apparatus **702**. The signal receiver apparatus **702** includes an analog-to-digital convertor **704**, a timing recovery circuit **706**, a lock detector circuit **708**, a voltage-controlled oscillator **710**, and an equaliser **712**. The timing recovery circuit **706** is represented by a dashed box, which is used for illustration purpose only. The timing recovery circuit **706** further includes a resampling block **706A**, a phase detector filter **706B**, a phase detector **706C**, and a timing recovery filter **706D**.

The signal receiver apparatus **702** includes suitable logic, circuitry, interfaces and/or code that is configured to receive an input signal 'r' from a signal transmitter apparatus. The goal of the signal receiver apparatus **702** is to synchronize the receiver clock signal with the transmission clock signal of the received signal (i.e., the input signal 'r'). Examples of the signal receiver apparatus **702** include, but are not limited to, a receiver, a base station, a repeater device, an Internet-of-Things (IoT) controller, a user device, a customized hardware for telecommunication, or any other portable or non-portable communication device or system.

The signal receiver apparatus **702** comprises at least one analog-to-digital convertor **704** (ADC) configured to quantize a received signal based on a receiver clock signal. The analog-to-digital convertor **704** refers to a system that converts an analog signal, such as a sound picked up by a microphone or light entering a digital camera, into a digital signal. Alternatively stated, the analog-to-digital convertor **704** refers to an electronic device that converts an input analog voltage or current to a digital number representing the magnitude of the voltage or current. Thus, the analog-to-digital convertor **704** quantises the signal received by the signal receiver apparatus **702** from the signal transmitter apparatus. The input to the analog-to-digital convertor **702** is represented by the input signal 'r'. The output of the analog-to-digital convertor **102** is represented by a quantized signal 'x'. Examples of analog-to-digital convertor **102** include, but are not limited to, direct-conversion or flash ADC, successive-approximation ADC, ramp-compare ADC, integrating ADC, delta-encoded or counter-ramp ADC, pipelined ADC, sigma-delta ADC, and many more.

The signal receiver apparatus **702** further comprises a timing recovery circuit **706** (TR) configured to generate a timing signal to synchronise the receiver clock signal with a transmission clock signal of the received signal. The timing recovery circuit **706** includes suitable logic, circuitry, interfaces and/or code that is configured to generate the timing signal, which synchronises the receiver clock signal with the transmission clock signal of the received signal (i.e., the quantised signal 'x'). However, small phase deviations are allowed since it is impossible to perfectly track the transmission clock signal. Examples of the timing recovery circuit **706** include, but are not limited to, phase-locked loop, delay-locked loop, Costas loop, and the alike.

In accordance with an embodiment, the timing recovery circuit **706** comprises a phase detection filter **706B** (PDFIL), and, optionally, a resampling block **706A** (RES) configured to generate an origin sample at an origin point T=0 of the quantised signal. The phase detection filter **706B** refers to a filter used before the phase detector **706C** to improve clock extraction. The phase detection filter **706B** can be avoided in good channel conditions (ISI is not serious). The resampling block **706A** refers to an interpolator used to generate samples at specific time instants when h>0. The resampling block **706A** is often realized as a finite impulse response filter (FIR). The resampling block **706A** and the phase detection filter **706B** can also be designed as a single FIR filter.

In accordance with an embodiment, the timing recovery circuit **706** further comprises a phase detector **706C** (PD) configured to generate timing information based the origin sample to indicate whether the receiver clock signal is faster or slower that the transmission clock signal. The phase detector **706C** refers to a frequency mixer, analog multiplier or logic circuit that generates a signal which represents the difference in phase between two signal inputs. The phase detector **706C** generates the timing information based the origin sample generated by the resampling block **706A** or the phase detection filter **706B**. The timing information includes phase details of the transmission clock signal, which are anticipated from the received signal (i.e., the input signal 'r'). Examples of the phase detector **706C** include, but are not limited to, a sample and hold circuit, a charge pump, or a logic circuit consisting of flip-flops.

In accordance with an embodiment, the lock detector circuit **708** is configured to generate timing information based at least two generated samples to indicate whether the receiver clock signal is faster or slower that the transmission clock signal. The lock detector circuit **708** corresponds to one of the lock detector circuits described for the timing recovery lock detector circuits **100**, **200**, **300**, **400**, **500**, and **600** (of FIGs. 1 to 6). The lock detector circuit **708** generates at least two samples at the two sampling points, i.e., first lock detector sampling phase (TEDC(LDSP1)) and second lock detector sampling phase (TEDC(LDSP2)), in the range of T= -0.25 UI to T= +0.25 UI such that TEDC(LDSP2)>TEDC(SP)>TEDC(LDSP1), where TEDC(SP) corresponds to the origin sample generated by the timing recovery circuit **706**. The result of the subtraction operation between the two samples indicates whether the receiver clock signal is faster or slower that the transmission clock signal.

In accordance with an embodiment, the signal receiver apparatus **702** further comprises a voltage-controlled oscillator **710** (VCO) configured to generate the timing signal based on the timing information. The voltage-controlled oscillator **710** refers to an electronic oscillator whose oscillation frequency is controlled by a voltage input, i.e., the applied input voltage determines the instantaneous oscillation frequency. The oscillation frequency of the voltage-controlled oscillator **710** varies from few hertz to hundreds of gigahertz (GHz). The voltage-controlled oscillator **710** generates timing signal based on the timing information provided by the timing recovery circuit **706**. The timing information is filtered out by the timing recovery filter **706D** before being sent to the voltage-controlled oscillator **710** because the timing information suffers from pattern-dependent noise, noise caused by amplifiers, component imperfections, and many other noise factors. Application areas of the voltage-controlled oscillator **710** include, but are not limited to, function generators, phase-locked loops, frequency synthesizers, clock generators, analog music synthesizers, electronic jamming equipment, and many more.

In accordance with an embodiment, the signal receiver apparatus **702** further comprises an equaliser **712**, configured to activate in response to the output signal from the lock detector circuit **708**. The equaliser **712** refers to a device that attempts to reverse the distortion incurred by a signal transmitted through a channel. The purpose of the equaliser **712** is to reduce inter symbol interference (ISI) to allow recovery of the transmit symbols. The equaliser **712** can be a simple linear filter or a complex algorithm. The equaliser is activated by the output signal of the lock detector logic block of the lock detector circuit **708**. Examples of the equaliser **712** include, but are not limited to, a linear equaliser, a zero-forcing equaliser, a decision feedback equaliser, a blind equaliser, an adaptive equaliser, a Viterbi equaliser, a turbo equaliser, and the like.

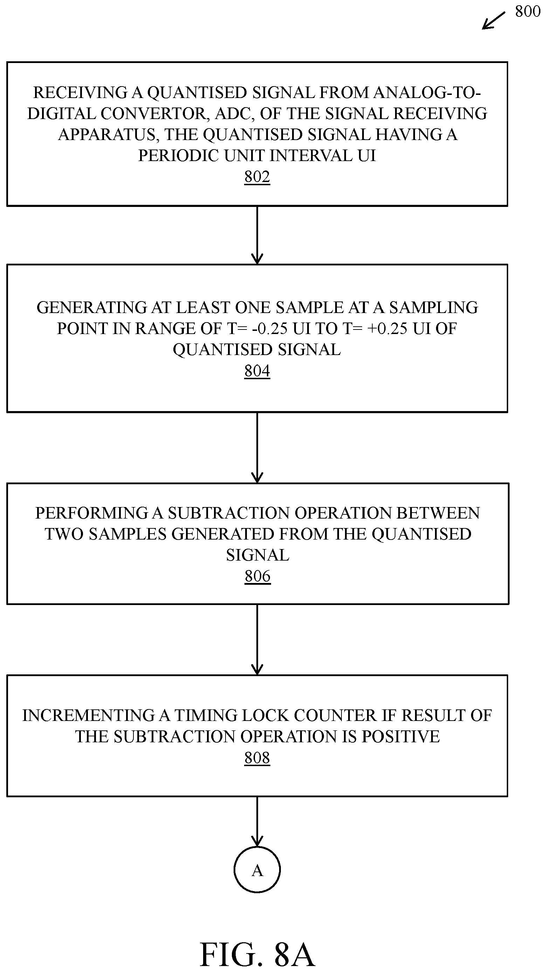

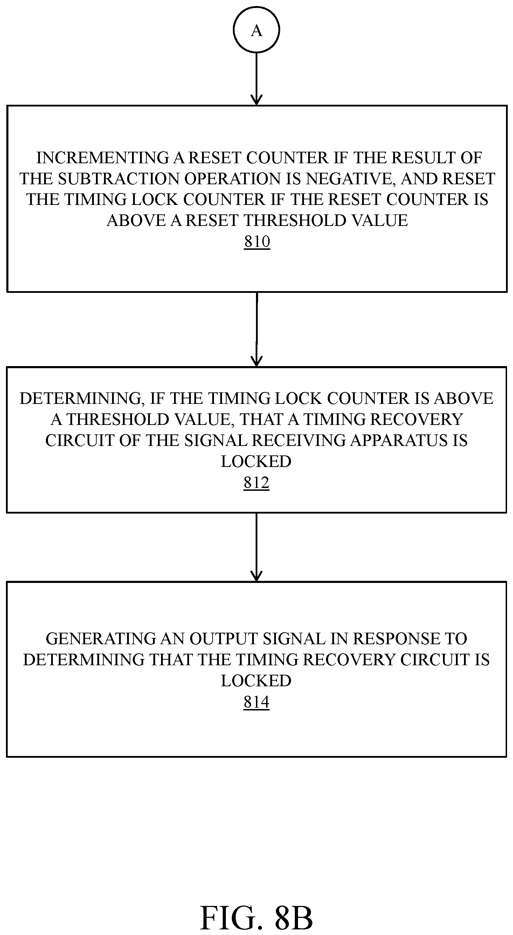

FIG. 8A and FIG. 8B, collectively, is a flowchart of a method of detecting a timing recovery lock in a signal receiver apparatus, in accordance with an embodiment of the present disclosure. FIG. 8A and FIG. 8B, collectively, is described in conjunction with elements from FIGs. 1, 2, 3, 4, 5, 6, and 7. With reference to FIG. 8A and FIG. 8B, there is shown a method **800**. The method **800** is executed by one of the timing recovery lock detector circuits **100**, **200**, **300**, **400**, **500**, and **600** (of FIGs. 1 to 6). The method **800** includes steps **802** to **814.**

At step **802**, the method **800** comprises receiving a quantised signal from an analog-to-digital convertor **704** (ADC) of the signal receiver apparatus **702**, the quantised signal having a periodic unit interval UI. The analog-to-digital convertor **704** quantises the signal received by the signal receiver apparatus **702** from a signal transmitter apparatus. The input to the analog-to-digital convertor **704** is represented by an input signal 'r'. The output of the analog-to-digital convertor **704** is represented by a quantized signal 'x'. The quantized signal 'x' has a periodic unit interval, i.e., the quantized signal 'x' repeats its values at regular unit intervals.

At step **804**, the method **800** further comprises generating at least one sample at a sampling point in the range of T= -0.25 UI to T= +0.25 UI of the quantised signal. The lock detector circuit **708** generates at least two samples at the two sampling points, i.e., first lock detector sampling phase (TEDC(LDSP1)) and second lock detector sampling phase (TEDC(LDSP2)), in the range of T= -0.25 UI to T= +0.25 UI such that TEDC(LDSP2)>TEDC(SP)>TEDC(LDSP1), where TEDC(SP) corresponds to the origin sample generated by the timing recovery circuit **706**.

At step **806**, the method **800** further comprises performing a subtraction operation between two samples generated from the quantised signal. The subtraction operation is performed between the two samples 'u1' and 'u2'. The first sample 'u1' is generated by the timing recovery circuit **706** at T=0. The second sample '$u_2$' is generated by the lock detector circuit **708** in the range of T= -0.25 UI to T= +0.25 UI. The subtraction operation performed to indicate whether the receiver clock signal is faster or slower that the transmission clock signal.

In accordance with an embodiment, the subtraction operation is performed between two samples generated by a lock detector circuit **708** of the signal receiver apparatus **702**. The first sample 'u$_1$' is generated by the timing recovery circuit **706**. The second sample 'u$_2$' is generated by the lock detector circuit **708**. The lock detector circuit **708** performs the subtraction operation between the two samples 'u$_2$' and 'u$_1$' such that w=u$_2$-u$_1$. The subtraction operation outputs information whether the sampling clock is faster or slower.

In accordance with an embodiment, the subtraction operation is performed between a sample generated by a lock detector circuit **708** of the signal receiver apparatus **702** and an origin sample generated by the timing recovery circuit **706** at an origin point T=0. The first sample 'u$_1$' is generated by the timing recovery circuit **706**. The timing recovery circuit **706** provides the first sample 'u$_1$' at a sampling point (SP), i.e., TEDC(SP), at zero-time unit interval (T= 0 UI), which is generated by the resampling block **706A**. Hence, the first sample 'u$_1$' generated by the timing recovery circuit **706** is also referred to as the origin sample. The second sample 'u$_2$' is generated by the lock detector circuit **708**. The lock detector circuit **708** provides the second sample 'u$_2$' at any one of the two sampling points, i.e., first lock detector sampling phase (TEDC(LDSP1)) and second lock detector sampling phase (TEDC(LDSP2)), in the range of T= -0.25 UI to T= +0.25 UI such that TEDC(LDSP2)>TEDC(SP)>TEDC(LDSP1). Further, the lock detector circuit 708 performs the subtraction operation between the two samples 'u$_2$' and 'u$_1$' such that w=u$_2$-u$_1$.

In accordance with an embodiment, the ADC is configured to process a plurality of symbols in parallel, and wherein the subtraction operation is performed between two averaged samples, generated by sampling each symbol at a common sampling point and averaging the result. In high-speed systems, 'N' symbols are processed in parallel during one application-specific integrated circuit (ASIC) clock and several ADCs can be used to quantize the input signal 'r'. Hence, the analog-to-digital convertor 704 is configured to process the plurality of symbols in parallel to generate the quantized signal 'x', which is configured to be real and one-dimensional. Further, the lock detector circuit 708 uses 'K' symbols (K≤N) to detect the timing recovery locking stage (locked or unlocked). The 'K' symbols are averaged to generate the samples at the common sampling point. Beneficially, the negative impact of sampling phase variations caused by sinusoidal jitter, clock offset variations, and random sampling phase variations (e.g., self-jitter) is eliminated.

In accordance with an embodiment, an order of the subtraction operation is based on the time order of the respective sampling points. The order of the subtraction operation (i.e., u$_1$-u$_2$ or u$_2$-u$_1$) is selected such that the earlier sample is subtracted from the later sample so as to ensure that the result of subtraction operation is positive. Beneficially, the clock of the signal receiver apparatus **702** is successfully synchronized with the clock of the signal transmitter apparatus.

At step **808**, the method **800** further comprises incrementing a timing lock counter if a result of the subtraction operation is positive. The lock detector circuit **708** increments the timing clock counter by 1 if the result of the subtraction operation is positive.

At step **810**, the method **800** further comprises increment a reset counter if the result of the subtraction operation is negative, and reset the timing lock counter if the reset counter is above a reset threshold value. The lock detector circuit **708** increments the reset counter by 1 if the result of the subtraction operation is negative and resets the timing lock counter if the reset counter is above the reset threshold value to indicate that the timing recovery circuit **706** is in the unlocked state (i.e., the receiver clock signal is not in sync with the transmission clock signal).

In accordance with an embodiment, the reset threshold value is one. The reset threshold value is used to detect the loss of lock/clock caused by some disturbances and to activate the timing recovery re-acquisition process. When the result of the subtraction operation between the two samples 'u$_1$' and 'u$_2$' is negative, the reset counter is incremented by one and the timing lock counter is reset to zero. Thus, to efficiently detect the loss of lock/clock, the reset threshold value is set to one so that as soon as the reset counter reaches one, the lock detector logic block **106E** declares the timing recovery circuit **104** to be in unlocked state.

At step **812**, the method **800** further comprises determining, if the timing lock counter is above a threshold value, that a timing recovery circuit **706** of the signal receiver apparatus **702** is locked. The lock detector circuit **708** determines that the timing recovery circuit **706** is in the locked state (i.e., the receiver clock signal is in sync with the transmission clock signal) if the timing lock counter is above a threshold value.

In accordance with an embodiment, the method **800** further comprising to determining, if the timing lock counter is reset, that the timing recovery circuit **706** is unlocked, and outputting an unlocked signal in response to determining that the timing recovery circuit **706** has changed from locked to unlocked. When the result of the subtraction operation between the two samples 'u$_1$' and 'u$_2$' is negative, the reset counter is incremented by one and the timing lock counter is reset to zero. Since the reset threshold value is set to one, the lock detector circuit **708** declares the timing recovery circuit **706** to be in unlocked state when the reset counter reaches the value one. Thus, the output signal of the lock detector circuit **708** determines that the timing recovery circuit **706** has changed from locked state to unlocked state and the timing recovery re-acquisition process is activated.

At step **814**, the method **800** further comprises generating an output signal in response to determining that the timing recovery circuit **706** is locked. The lock detector logic block of the lock detector circuit **708** generates the output signal indicating the locked state of the timing recovery circuit 706. The output signal fed to the equaliser **712**, which reduces inter symbol interference (ISI) to allow recovery of the transmit symbols.

In accordance with an embodiment, the output signal is configured to activate one or more modules of the signal receiver apparatus 702. The output signal is generated by the lock detector logic block of the lock detector circuit 708. The output signal provides information about the timing recovery status, i.e., whether the timing recovery circuit 706 is locked or unlocked (loss of lock). The output signal is fed to the equaliser 712. Thus, the lock detector circuit 708 announces acquisition if specific conditions are fulfilled and activates one or more modules of the signal receiver apparatus 702, such as the equaliser 712. On the other hand, after sometime the lock detector logic circuit 708 can detect loss of lock/clock caused by some disturbances and activates the timing recovery re-acquisition process.

Thus, the method 800 generates two samples 'u$_1$' and 'u$_2$', where the first sample is generated by the timing recovery circuit 706 and the second sample is generated by the lock detector circuit 708. The timing recovery circuit 706 generates the first sample (or the origin sample) at the origin point T=0. The lock detector circuit 708 generates the second sample in the range of T = -0.25 UI to T = +0.25 UI. The subtraction operation is performed between the two samples. If the result of the subtraction operation is positive, timing lock counter is incremented. If the result of the subtraction operation is negative, reset counter is incremented and the timing lock counter is reset if the reset counter is above the reset threshold value, which is set to one. Hence, the lock detector circuit 708 determines that the timing recovery circuit 706 is in locked state if the timing lock counter is set. On the other hand, the lock detector circuit 708 determines that the timing recovery circuit 706 is in unlocked state if the timing lock counter is reset, and activates the timing recovery re-acquisition process. Further, the method 800 can use phase detector mode or phase-frequency mode for clock extraction and is applicable for oversampled systems as well as on single-sample per symbol systems. Moreover, the method 800 does not depend on channel conditions because the lock detector circuit 708 sets locking parameters independent of the inter-symbol interference, noise, and other channel distortions.

The steps 802 to 814 are only illustrative and other alternatives can also be provided where one or more steps are added, one or more steps are removed, or one or more steps are provided in a different sequence without departing from the scope of the claims herein.

FIG. 9 is a schematic diagram of a lock detector logic block, in accordance with an embodiment of the present disclosure. FIG. 9 is described in conjunction with elements from FIGs. 1, 2, 3, 4, 5, 6, 7, 8A, and 8B. With reference to FIG. 9, there is shown a lock detector logic block 900 that includes an infinite impulse response filter 902, a clock divider 904, a sign extractor 906, a timing lock counter 908, and a decision block 910.

The lock detector logic block 900 corresponds to one of the lock detector logic blocks 106E, 206D, 310, 408, 510, and 608 (of FIGs. 1 to 6). The lock detector logic block 900 provides information about the timing recovery status, i.e., whether the timing circuit 706 is locked or unlocked (loss of lock). The application specific integrated circuit (ASIC) frequency is referred to as 'f$_s$/N', where 'f$_s$' denotes a symbol frequency (rate). The infinite impulse response filter 902 can be referred to as a first-order filter defined by s(n)=(1-$\alpha$)s(n-1)+$\alpha$w. The value '$\alpha$' is carefully selected depending on 'f$_s$' and 'N' such that 0.0001<$\alpha$<0.001. The lock detector logic block 900 uses three additional parameters: 'G', 'p$_1$', and 'p$_2$'. The parameter 'G' refers to the checking frequency of lock control signal 's'. The frequency 'f$_{ASIC}$ /G' refers to a clock frequency generated by the clock divider 904. The frequency 'f$_{ASIC}$ /G' is fed to all the blocks in the lock detector logic block 900 after the infinite impulse response filter 902. The parameter 'G' can be set to 128 that means that the infinite impulse response filter 902 output signal 's' will be checked with a frequency 128 times slower than f$_{ASIC}$. The parameter 'p$_1$' refers to first lock detection threshold. The parameter 'p$_1$' can be set to zero, however, other values larger than 0 can also to selected. To ensure a proper lock detection, the signal 's' is multiplied by sign($\tau_j$-$\tau_{j-1}$). The sign extractor 906 computes the sign of the difference s$_1$-s$_0$ as $\pm$1. The output of the sign extractor 906 is fed into the timing lock counter 908, which is limited by a parameter 'p$_2$'. The parameter 'p$_2$' refers to second lock detection threshold. The timing lock counter 908 increases a value by 1 when s$_2$=1 and when the old value s$_3$ is s$_3$<p$_2$. On the other hand, when s$_2$=-1, the timing lock counter 908 is reset to 0. When the timing lock counter 908 value s$_3$ is s$_3$$\geq$p$_3$, the signal s$_4$ becomes s4$\geq$0 and the decision block 910 determines that the timing recovery circuit 706 is locked otherwise it is unlocked. Further, the parameters 'p$_3$' can be set to 'p$_2$' and the locking will be indicated when s$_4$=0.

FIG. 10A is a graphical representation that depicts a phase detector filter and phase detector filter taps, in accordance with an embodiment of the present disclosure. FIG. 10A is described in conjunction with elements from FIG. 1, 2, 3, 4, 5, 6, 7, 8A, and 8B. With reference to FIG. 10A, there is shown a graphical representation 1000A that depicts a phase detector filter and phase detector filter taps.

The graphical representation 1000A represents relative time in unit interval (UI) on an X-axis 1002 and values of amplitude of timing error detector characteristic (TEDC/A) on a Y-axis 1004. There is further shown a plurality of lines 1006 representing four 5-tap phase detector filters. When the phase detector filter (PDFIL) taps are known (used when strong ISI exists), the PDFILn (where n=1,2,3) taps 'd' are derived by modifying PDFIL taps c = (c$_0$ c$_1$ ... c$_{M-1}$) such that 'd' is defined by Equation 1.

$$d = ifft(fft(c) * \exp(-j\omega\tau)) \qquad\qquad (Eq. 1)$$

Where, Fourier transformation is denoted by fft, inverse Fourier transformation is denoted by ifff, $\omega$ is angular frequency, $j$ is square root of -1, and $\tau$ is phase shift in unit interval (UI) such that $-1/4\text{UI} \leq \tau \leq 1/4\text{UI}$ (UI=1 when 1 sample per symbol is used). Further, when PDFIL is not used/implemented, for M= 5 c= (0 0 1 0 0) can be used to derive PDFILn.

FIG. 10B is a graphical representation that depicts a timing error detector characteristic curve for a phase detector filter, in accordance with an embodiment of the present disclosure. FIG. 10B is described in conjunction with elements from FIG. 1, 2, 3, 4, 5, 6, 7, 8A, 8B, and 10A. With reference to FIG. 10B, there is shown a graphical representation **1000B** that depicts timing error detector characteristic curve for a phase detector filter.

The graphical representation **1000B** represents relative time in unit interval (UI) on an X-axis **1008** and values of amplitude of timing error detector characteristic (TEDC/A) on a Y-axis **1010**. There is further shown a plurality of lines **1012** representing phase detector filter (PDFIL) with $\tau=\pm\text{UI}/4$. Two PDFILn are derived by using the PDFIL while one of them does not use the PDFIL. From the graphical representation **1000B**, it can be observed that when $\tau=\pm\text{UI}/4$, the difference $u_2-u_1$ is positive/negative and the signal 's' after the infinite impulse response block also becomes positive/negative if the timing recovery works well. Further, if $\text{abs(TEDC(-UI/4))>abs(TEDC(+UI/4))}$ (i.e., asymmetrical TEDC), it is better to select $\tau<0$.

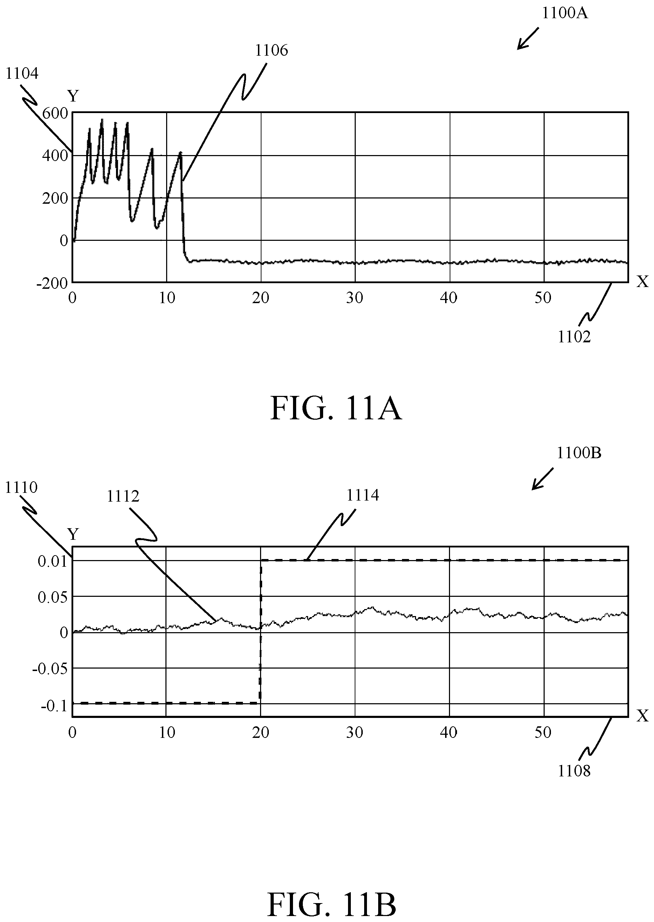

FIG. 11A is a graphical representation that depicts an estimated clock offset during acquisition, in accordance with an embodiment of the present disclosure. FIG. 11A is described in conjunction with elements from FIG. 1, 2, 3, 4, 5, 6, 7, 8A, and 8B. With reference to FIG. 11A, there is shown a graphical representation **1100A** that depicts an estimated clock offset during acquisition.

The results in the graphical representation **1100A** are obtained by considering 112 gigabauds (GB) pulse amplitude modulation 4 (PAM4) signal with -100 parts per million (ppm) clock offset and a sinusoidal jitter. Further, the parameters are set as N=128, $\alpha$=0.0004, G=100, $p_1$=0, and $p_2=p_3$=100. The graphical representation **1100A** represents relative time in microseconds ($\mu$s) on an X-axis **1102** and values of clock offset in parts per million (ppm) on a Y-axis **1104**. There is further shown a clock offset curve **1106**. From the graphical representation **1100A**, it can be observed that the phase-frequency detector timing recovery circuit gets stable after 12 $\mu$s.

FIG. 11B is a graphical representation that depicts lock detector signals, in accordance with an embodiment of the present disclosure. FIG. 11B is described in conjunction with elements from FIG. 1, 2, 3, 4, 5, 6, 7, 8A, 8B, and 11A. With reference to FIG. 11B, there is shown a graphical representation **1100B** that depicts lock detector signal.

The results in the graphical representation **1100B** are obtained by considering 112 gigabauds (GB) pulse amplitude modulation 4 (PAM4) signal with -100 parts per million (ppm) clock offset and a sinusoidal jitter. Further, the parameters are set as N=128, $\alpha$=0.0004, G=100, $p_1$=0, and $p_2=p_3$=100. The graphical representation **1100B** represents relative time in microseconds ($\mu$s) on an X-axis **1108** and values of locking on a Y-axis **1110**. There is further shown a clock offset curve **1112** and lock detector signal **1114** (represented by dashed lines). From the graphical representation **1100B**, it can be observed that the phase-frequency detector timing recovery circuit gets stable after 12 $\mu$s and the lock detector circuit needs 8 $\mu$s to detect and announce the successive lock. Further, the higher dash line value indicates lock while the lower negative value indicates loss of lock.

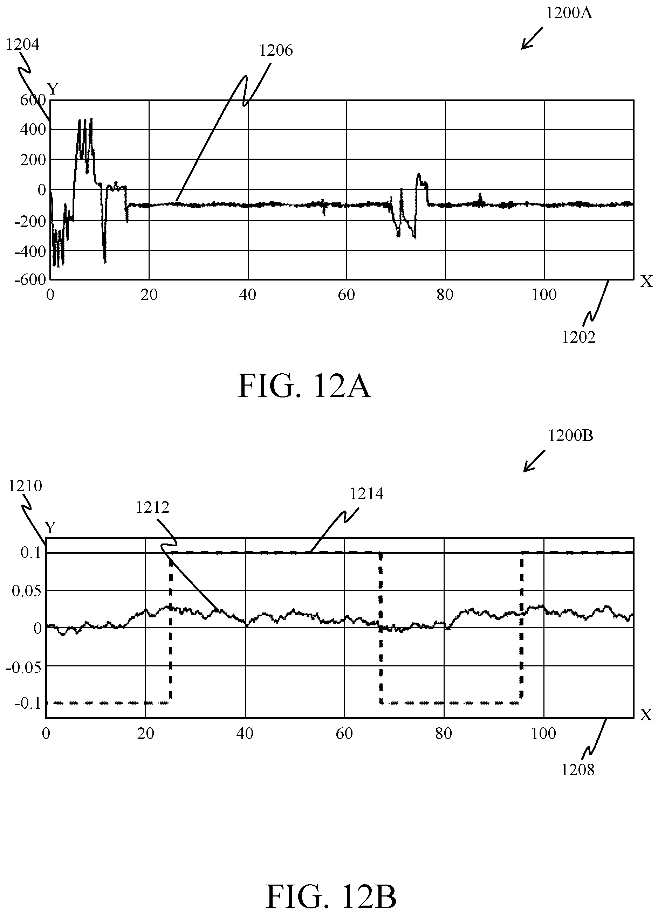

FIG. 12A is a graphical representation that depicts an estimated clock offset during acquisition, in accordance with another embodiment of the present disclosure. FIG. 12A is described in conjunction with elements from FIG. 1, 2, 3, 4, 5, 6, 7, 8A, and 8B. With reference to FIG. 12A, there is shown a graphical representation **1200A** that depicts an estimated clock offset during acquisition.

The results in the graphical representation **1200A** are obtained by considering the same parameters, which were used to obtain FIG. 11A, but with some loop parameters changed to cause more timing recovery instability. The graphical representation **1200A** represents relative time in microseconds ($\mu$s) on an X-axis **1202** and values of clock offset in parts per million (ppm) on a Y-axis **1204**. There is further shown a clock offset curve **1206**. From the graphical representation **1200A**, it can be observed that there are two critical regions where the timing recovery does not work.

FIG. 12B is a graphical representation that depicts lock detector signal, in accordance with another embodiment of the present disclosure. FIG. 12B is described in conjunction with elements from FIG. 1, 2, 3, 4, 5, 6, 7, 8A, 8B, and 12A. With reference to FIG. 12B, there is shown a graphical representation **1200B** that depicts lock detector signal.

The results in the graphical representation **1200B** are obtained by considering the same parameters, which were used to obtain FIG. 11B, but with some loop parameters changed to cause more timing recovery instability. The graphical representation **1200B** represents relative time in microseconds ($\mu$s) on an X-axis **1208** and values of locking on a Y-axis **1210**. There is further shown a clock offset curve **1212** and lock detector signal **1214** (represented by dashed lines). From the graphical representation **1200B**, it can be observed that there are two critical regions where the timing recovery does not work and the lock detector circuit detects these regions reliably. Further, the higher dash line value indicates lock while the lower negative value indicates loss of lock.

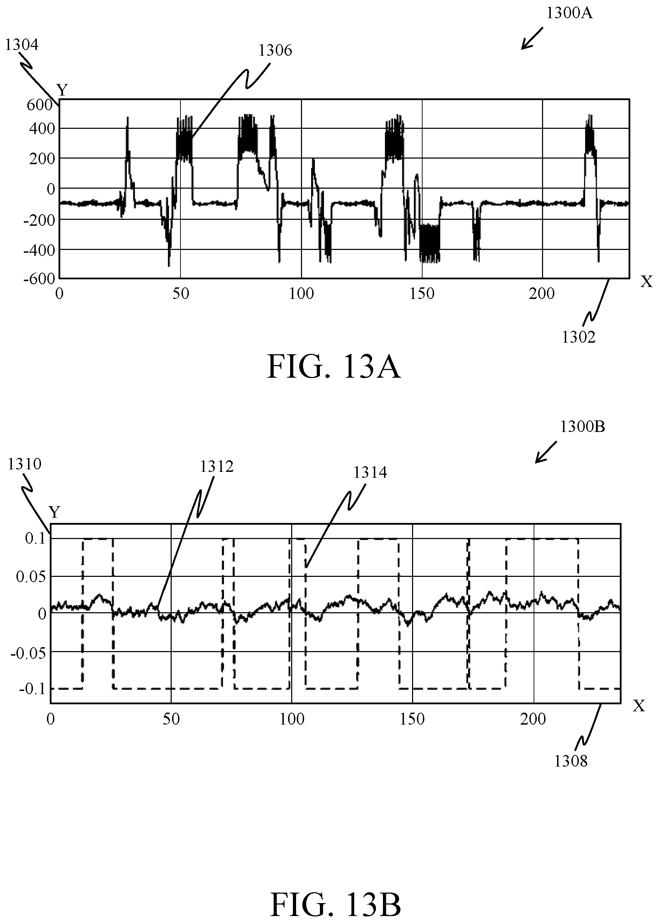

FIG. 13A is a graphical representation that depicts an estimated clock offset during acquisition, in accordance with yet another embodiment of the present disclosure. FIG. 13A is described in conjunction with elements from FIG. 1, 2, 3, 4, 5, 6, 7, 8A, and 8B. With reference to FIG. 13A, there is shown a graphical representation **1300A** that depicts an estimated clock offset during acquisition.

The results in the graphical representation **1300A** are obtained by considering the same parameters, which were used to obtain FIG. 11A, but with some loop parameters changed to cause even more drastic timing recovery instability. The graphical representation **1300A** represents relative time in microseconds (μs) on an X-axis **1302** and values of clock offset in parts per million (ppm) on a Y-axis **1304**. There is further shown a clock offset curve **1306**. From the graphical representation **1300A**, it can be observed that there are several critical regions where the timing recovery does not work.

FIG. 13B is a graphical representation that depicts lock detector signal, in accordance with yet another embodiment of the present disclosure. FIG. 13B is described in conjunction with elements from FIG. 1, 2, 3, 4, 5, 6, 7, 8A, 8B, and 13A. With reference to FIG. 13B, there is shown a graphical representation **1300B** that depicts lock detector signal.

The results in the graphical representation **1300B** are obtained by considering the same parameters, which were used to obtain FIG. 11B, but with some loop parameters changed to cause even more drastic timing recovery instability. The graphical representation **1300B** represents relative time in microseconds (μs) on an X-axis **1308** and values of locking on a Y-axis **1310**. There is further shown a clock offset curve **1312** and lock detector signal **1314** (represented by dashed lines). From the graphical representation **1300B**, it can be observed that there are several critical regions where the timing recovery does not work and the lock detector circuit detects all these regions reliably. Further, the higher dash line value indicates lock while the lower negative value indicates loss of lock.

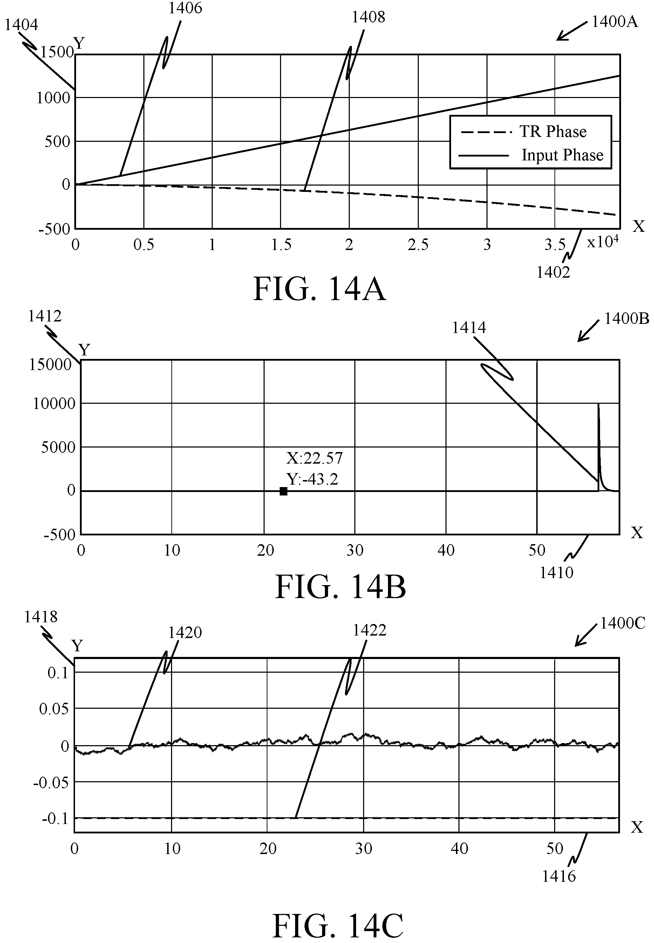

FIG. 14A is a graphical representation that depicts timing recovery and input phases, in accordance with yet another embodiment of the present disclosure. FIG. 14A is described in conjunction with elements from FIG. 1, 2, 3, 4, 5, 6, 7, 8A, and 8B. With reference to FIG. 14A, there is shown a graphical representation **1400A** that depicts timing recovery and input phases.

The results in the graphical representation **1400A** are obtained by considering the same parameters, which were used to obtain FIG. 11A, but with phase detection mode and some loop parameters changed to cause timing recovery to be unstable. The graphical representation **1400A** represents block numbers on an X-axis **1402** and values of sampling phase on a Y-axis **1404**. There is further shown an input phase curve **1406** and a timing recovery phase curve **1408** (represented by dashed lines). From the graphical representation **1400A**, it can be observed that the timing recovery does not work.

FIG. 14B is a graphical representation that depicts an estimated clock offset during acquisition, in accordance with yet another embodiment of the present disclosure. FIG. 14B is described in conjunction with elements from FIG. 1, 2, 3, 4, 5, 6, 7, 8A, 8B, and 14A. With reference to FIG. 14B, there is shown a graphical representation **1400B** that depicts an estimated clock offset during acquisition.

The results in the graphical representation **1400B** are obtained by considering the same parameters, which were used to obtain FIG. 11A, but with phase detection mode and some loop parameters changed to cause timing recovery to be unstable. The graphical representation **1400B** represents relative time in microseconds (μs) on an X-axis **1410** and values of clock offset in parts per million (ppm) on a Y-axis **1412**. There is further shown a clock offset curve **1414**. From the graphical representation **1400B**, it can be observed when the clock offset was set to 200 ppm, the timing recovery works with the offset of -43 ppm.

FIG. 14C is a graphical representation that depicts lock detector signal, in accordance with yet another embodiment of the present disclosure. FIG. 14C is described in conjunction with elements from FIG. 1, 2, 3, 4, 5, 6, 7, 8A, 8B, 14A, and 14B. With reference to FIG. 14B, there is shown a graphical representation **1400B** that depicts lock detector signal.

The results in the graphical representation **1400C** are obtained by considering the same parameters, which were used to obtain FIG. 11B, but with phase detection mode and some loop parameters changed to cause timing recovery to be unstable. The graphical representation **1400C** represents relative time in microseconds (μs) on an X-axis **1416** and values of locking on a Y-axis **1418**. There is further shown a clock offset curve **1420** and lock detector signal **1422** (represented by dashed lines). From the graphical representation **1400C**, it can be observed that the timing recovery circuit is unlocked.

Various embodiments of the disclosure thus provide a timing recovery lock detector circuit **100, 200, 300, 400, 500, 600** (LD) for a signal receiver apparatus **702**, configured to: receive a quantised signal from an analog-to-digital convertor **102, 202, 704** (ADC) of the signal receiver apparatus **702**, the quantised signal having a periodic unit interval (UI) generate at least one sample at a sampling point in the range of T= -0.25 UI to T= +0.25 UI of the quantised signal; perform a subtraction operation between two samples generated from the quantised signal; increment a timing lock counter if a result of the subtraction operation is positive; increment a reset counter if the result of the subtraction operation is negative, and reset the timing lock counter if the reset counter is above a reset threshold value; determine, if the timing lock counter is above a lock threshold value, that a timing recovery circuit **104, 204, 706** of the signal receiver apparatus is locked; and generate an output signal in response to determining that the timing recovery circuit **104, 204, 706** is locked.

Various embodiments of the disclosure thus further provide the signal receiver apparatus **702**. The signal receiver apparatus **702** comprises at least one analog-to-digital convertor **102, 202, 704** (ADC) configured to quantize a received signal based on a receiver clock signal. The signal receiver apparatus **702** further comprises a timing recovery circuit **104, 204, 706** (TR) configured to generate a timing signal to synchronise the receiver clock signal with a transmission clock signal of the received signal. The signal receiver apparatus **702** further comprises the lock detector circuit **106, 206, 708** of the aforementioned aspect.

Various embodiments of the disclosure thus may further provide a method **800** of detecting a timing recovery lock in a signal receiver apparatus **702**. The method **800** comprises: receiving a quantised signal from an analog-to-digital convertor **102, 202, 704** (ADC) of the signal receiver apparatus **702**, the quantised signal having a periodic unit interval UI; generating at least one sample at a sampling point in the range of T= -0.25 UI to T= +0.25 UI of the quantised signal; performing a subtraction operation between two samples generated from the quantised signal; incrementing a timing lock counter if a result of the subtraction operation is positive; increment a reset counter if the result of the subtraction operation is negative, and reset the timing lock counter if the reset counter is above a reset threshold value; determining, if the timing lock counter is above a threshold value, that a timing recovery circuit **104, 204, 706** of the signal receiver apparatus **702** is locked; and generating an output signal in response to determining that the timing recovery circuit **104, 204, 706** is locked.

Modifications to embodiments of the present disclosure described in the foregoing are possible without departing from the scope of the present disclosure as defined by the accompanying claims. Expressions such as "including", "comprising", "incorporating", "have", "is" used to describe and claim the present disclosure are intended to be construed in a non-exclusive manner, namely allowing for items, components or elements not explicitly described also to be present. Reference to the singular is also to be construed to relate to the plural. The word "exemplary" is used herein to mean "serving as an example, instance or illustration". Any embodiment described as "exemplary" is not necessarily to be construed as preferred or advantageous over other embodiments and/or to exclude the incorporation of features from other embodiments. The word "optionally" is used herein to mean "is provided in some embodiments and not provided in other embodiments". It is appreciated that certain features of the present disclosure, which are, for clarity, described in the context of separate embodiments, may also be provided in combination in a single embodiment. Conversely, various features of the present disclosure, which are, for brevity, described in the context of a single embodiment, may also be provided separately or in any suitable combination or as suitable in any other described embodiment of the disclosure.

## Claims

1. A timing recovery lock detector circuit (100, 200, 300, 400, 500, 600), LD, for a signal receiver apparatus (702), configured to:

   receive a quantised signal from an analog-to-digital convertor (102, 202, 704), ADC, of the signal receiver apparatus (702), the quantised signal having a periodic unit interval, UI;
   generate at least two samples at two sampling points in the range of T= -0.25 UI to T= +0.25 UI of the quantised signal;
   perform a subtraction operation between two samples of the at least two samples generated from the quantised signal;
   increment a timing lock counter if a result of the subtraction operation is positive;
   increment a reset counter if the result of the subtraction operation is negative, and reset the timing lock counter if the reset counter is above a reset threshold value;
   determine, if the timing lock counter is above a lock threshold value, that a timing recovery circuit (104, 204, 706) of the signal receiver apparatus (702) is locked; and
   generate an output signal in response to determining that the timing recovery circuit (104, 204, 706) is locked, wherein an order of the subtraction operation is selected such that an earlier sample is subtracted from an later sample.

2. The timing recovery lock detector circuit (100, 200, 300, 400, 500, 600) of claim 1, wherein the subtraction operation is performed between two samples generated by the LD.

3. The timing recovery lock detector circuit (100, 200, 300, 400, 500, 600) of claim 1, wherein the subtraction operation is performed between a sample generated by the LD and an origin sample generated by the timing recovery circuit (104, 204, 706) at an origin point T=0.

4. The timing recovery lock detector circuit (100, 200, 300, 400, 500, 600) of any preceding claim, wherein the ADC is configured to process a plurality of symbols in parallel, and wherein the subtraction operation is performed between two averaged samples, generated by sampling each symbol at a common sampling point and averaging the result.

5. The timing recovery lock detector circuit (100, 200, 300, 400, 500, 600) of any preceding claim, wherein the output signal is configured to activate one or more modules of the signal receiver apparatus (702).

6. The timing recovery lock detector circuit (100, 200, 300, 400, 500, 600) of any preceding claim, wherein the reset threshold value is one.

7. The timing recovery lock detector circuit (100, 200, 300, 400, 500, 600) of any preceding claim, further configured to determine, if the timing lock counter is reset, that the timing recovery circuit (102, 202, 706) is unlocked, and to output an unlocked signal in response to determining that the timing recovery circuit (102, 202, 706) has changed from locked to unlocked.

8. The timing recovery lock detector circuit (100, 200, 300, 400, 500, 600) of any preceding claim, comprising a phase detection filter (104B, 106B, 204A, 206A, 304A, 304B, 402A, 402B, 504A, 504B, 602A, 602B, 706B), PDFIL, and, optionally, a resampling block (104A, 106A, 302A, 302B, 502A, 502B, 706A), RES, configured to generate the at least one sample.

9. A signal receiver apparatus (702), comprising:

at least one analog-to-digital convertor (102, 202, 704), ADC, configured to quantize a received signal based on a receiver clock signal;
a timing recovery circuit (104, 204, 706), TR, configured to generate a timing signal to synchronise the receiver clock signal with a transmission clock signal of the received signal; and
the lock detector circuit (106, 206, 708) of any preceding claim.

10. The signal receiver apparatus (702) of claim 9, wherein the resampling block (104A, 106A, 302A, 302B, 502A, 502B, 706A), RES, is further configured to generate an origin sample at an origin point T=0 of the quantised signal.

11. The signal receiver apparatus (702) of claim 10, further comprising a phase detector (104C, 106C, 204B, 206B, 306A, 306B, 404A, 404B, 506A, 506B, 604A, 604B), PD, configured to generate timing information based the origin sample to indicate whether the receiver clock signal is faster or slower that the transmission clock signal.

12. The signal receiver apparatus (702) of claim 9, wherein the lock detector circuit (106, 206, 708) is configured to generate timing information based at least two generated samples to indicate whether the receiver clock signal is faster or slower that the transmission clock signal.

13. The signal receiver apparatus (702) of claim 10 or claim 11, further comprising a voltage-controlled oscillator (108, 208, 710), VCO, configured to generate the timing signal based on the timing information.

14. The signal receiver apparatus (702) of any one of claims 9 to 13, further comprising an equaliser (110, 210, 712), configured to be activated in response to the output signal from the lock detector circuit (106, 206, 708).

**Patentansprüche**

1. Detektorschaltung der Einrastung einer Taktrückgewinnung (100, 200, 300, 400, 500, 600), LD, für eine Signalempfangsvorrichtung (702), die zu Folgendem konfiguriert ist:

Empfangen eines quantisierten Signals von einem Analog-Digital-Wandler (102, 202, 704), ADC, der Signalempfangsvorrichtung (702), wobei das quantisierte Signal ein periodisches Einheitsintervall, UI, aufweist;
Generieren von mindestens zwei Abtastwerten an zwei Abtastpunkten im Bereich von T = -0,25 UI bis T = +0,25 UI des quantisierten Signals.
Durchführen einer Subtraktionsoperation zwischen zwei Abtastwerten der mindestens zwei Abtastwerte, die aus dem quantisierten Signal erzeugt wurden;
Erhöhen einer Einrastung des Taktzählers, wenn das Ergebnis der Subtraktionsoperation positiv ist.
Erhöhen eines Rücksetzzählers, wenn das Ergebnis der Subtraktionsoperation negativ ist, und zurücksetzen der Einrastung des Taktzählers, wenn der Rücksetzzähler über einem Rücksetzschwellenwert liegt;
Bestimmen, dass eine Taktrückgewinnungsschaltung (104, 204, 706) der Signalempfangsvorrichtung (702) eingerastet ist, wenn die Einrastung des Taktzählers über einem Einrastungsschwellenwert liegt; und
Erzeugen eines Ausgangssignals als Reaktion auf die Feststellung, dass die Taktrückgewinnungsschaltung (104, 204, 706) eingerastet ist,
wobei eine Reihenfolge der Subtraktionsoperation so gewählt wird, dass ein früherer Abtastwert von einem späteren Abtastwert subtrahiert wird.

2. Detektorschaltung der Einrastung einer Taktrückgewinnung (100, 200, 300, 400, 500, 600) nach Anspruch 1, wobei die Subtraktionsoperation zwischen zwei von der LD erzeugten Abtastwerten durchgeführt wird.

3. Detektorschaltung der Einrastung einer Taktrückgewinnung (100, 200, 300, 400, 500, 600) nach Anspruch 1, wobei die Subtraktionsoperation zwischen einem durch den LD erzeugten Abtastwert und einer durch die Taktrückgewinnungsschaltung (104, 204, 706) an einem Ursprungspunkt T=0 erzeugten Ursprungsabtastwert durchgeführt wird.

4. Detektorschaltung der Einrastung einer Taktrückgewinnung (100, 200, 300, 400, 500, 600) nach einem der vorhergehenden Ansprüche, wobei der ADC so konfiguriert ist, dass er mehrere Symbole parallel verarbeitet, und wobei die Subtraktionsoperation zwischen zwei gemittelten Abtastwerten durchgeführt wird, die durch Abtasten jedes Symbols an einem gemeinsamen Abtastpunkt und Mitteln des Ergebnisses erzeugt werden.

5. Detektorschaltung der Einrastung einer Taktrückgewinnung (100, 200, 300, 400, 500, 600) nach einem der vorhergehenden Ansprüche, wobei das Ausgangssignal dazu konfiguriert ist, ein oder mehrere Module der Signalempfängervorrichtung (702) zu aktivieren.

6. Detektorschaltung der Einrastung einer Taktrückgewinnung (100, 200, 300, 400, 500, 600) nach einem der vorhergehenden Ansprüche, wobei der Rücksetzschwellenwert eins ist.

7. Detektorschaltung der Einrastung einer Taktrückgewinnung (100, 200, 300, 400, 500, 600) nach einem der vorhergehenden Ansprüche, die außerdem dazu konfiguriert ist, bei einem Zurücksetzen des Taktrückgewinnungszählers festzustellen, dass die Taktrückgewinnungsschaltung (102, 202, 706) nicht eingerastet ist, und als Reaktion auf die Feststellung, dass die Taktrückgewinnungsschaltung (102, 202, 706) von eingerastet auf nicht eingerastet ist, ein Entraastiungssignal auszugeben.

8. Detektorschaltung der Einrastung einer Taktrückgewinnung (100, 200, 300, 400, 500, 600) nach einem der vorhergehenden Ansprüche, umfassend ein Phasendetektionsfilter (104B, 106B, 204A, 206A, 304A, 304B, 402A, 402B, 504A, 504B, 602A, 602B, 706B), PDFIL, und optional einen Block zur erneuten Abtastung (104A, 106A, 302A, 302B, 502A, 502B, 706A), RES, der dazu konfiguriert ist, die mindestens eine Abtastung zu erzeugen.

9. Signalempfängervorrichtung (702), umfassend:

mindestens einen Analog-Digital-Wandler (102, 202, 704), ADC, der dazu konfiguriert ist, ein empfangenes Signal basierend auf einem Empfängertaktsignal zu quantisieren;
eine Taktrückgewinnungsschaltung (104, 204, 706), TR, die dazu konfiguriert ist, ein Taktsignal zu erzeugen, um das Empfängertaktsignal mit einem Übertragungstaktsignal des empfangenen Signals zu synchronisieren; und
die Detektorschaltung der Einrastung (106, 206, 708) nach einem der vorhergehenden Ansprüche.

10. Signalempfangsvorrichtung (702) nach Anspruch 9, wobei der Block zur erneuten Abtastung (104A, 106A, 302A, 302B, 502A, 502B, 706A), RES, ferner dazu konfiguriert ist, eine Ursprungsprobe an einem Ursprungspunkt T=0 des quantisierten Signals zu erzeugen.

11. Signalempfangsvorrichtung (702) nach Anspruch 10, außerdem umfassend einen Phasendetektor (104C, 106C, 204B, 206B, 306A, 306B, 404A, 404B, 506A, 506B, 604A, 604B), PD, der dazu konfiguriert ist, auf der Grundlage des Ursprungsabtastwerts Zeitinformationen zu erzeugen, um anzuzeigen, ob das Empfängertaktsignal schneller oder langsamer als das Übertragungstaktsignal ist.

12. Signalempfangsvorrichtung (702) nach Anspruch 9, wobei die Detektorschaltung der Einrastung (106, 206, 708) dazu konfiguriert ist, auf der Grundlage von mindestens zwei generierten Abtastwerten Zeitinformationen zu erzeugen, um anzuzeigen, ob das Empfängertaktsignal schneller oder langsamer als das Übertragungstaktsignal ist.

13. Signalempfangsvorrichtung (702) nach Anspruch 10 oder Anspruch 11, außerdem umfassend einen spannungsgesteuerten Oszillator (108, 208, 710), VCO, der dazu konfiguriert ist, das Zeitsignal basierend auf den Zeitinformationen zu erzeugen.

**14.** Signalempfangsvorrichtung (702) nach einem der Ansprüche 9 bis 13, außerdem umfassend einen Entzerrer (110, 210, 712), der so konfiguriert ist, dass er als Reaktion auf das Ausgangssignal der Detektorschaltung der Einrastung (106, 206, 708) aktiviert wird.

**Revendications**

**1.** Circuit détecteur de verrouillage de la récupération d'horloge (100, 200, 300, 400, 500, 600), LD, pour un appareil récepteur de signaux (702), configuré pour :

recevoir un signal quantifié à partir d'un convertisseur analogique-numérique (102, 202, 704), ADC, de l'appareil récepteur de signaux (702), le signal quantifié ayant un intervalle unitaire, UI, périodique ;
générer au moins deux échantillons au niveau de deux points d'échantillonnage dans la plage de T = -0,25 UI à T = +0,25 UI du signal quantifié ;
exécuter une opération de soustraction entre deux échantillons des au moins deux échantillons générés à partir du signal quantifié ;
incrémenter un compteur de verrouillage d'horloge si un résultat de l'opération de soustraction est positif ;
incrémenter un compteur de réinitialisation si le résultat de l'opération de soustraction est négatif, et réinitialiser le compteur de verrouillage d'horloge si le compteur de réinitialisation est supérieur à une valeur seuil de réinitialisation ;
déterminer, si le compteur de verrouillage d'horloge est supérieur à une valeur seuil de verrouillage, qu'un circuit de récupération d'horloge (104, 204, 706) de l'appareil récepteur de signaux (702) est verrouillé ; et
générer un signal de sortie en réponse à la détermination que le circuit de récupération d'horloge (104, 204, 706) est verrouillé,
dans lequel un ordre de l'opération de soustraction est sélectionné de sorte qu'un échantillon antérieur est soustrait d'un échantillon ultérieur.

**2.** Circuit détecteur de verrouillage de la récupération d'horloge (100, 200, 300, 400, 500, 600) selon la revendication 1, dans lequel l'opération de soustraction est exécutée entre deux échantillons générés par le LD.

**3.** Circuit détecteur de verrouillage de la récupération d'horloge (100, 200, 300, 400, 500, 600) selon la revendication 1, dans lequel l'opération de soustraction est exécutée entre un échantillon généré par le LD et un échantillon d'origine généré par le circuit de récupération d'horloge (104, 204, 706) au niveau d'un point d'origine T = 0.

**4.** Circuit détecteur de verrouillage de la récupération d'horloge (100, 200, 300, 400, 500, 600) selon une quelconque revendication précédente, dans lequel l'ADC est configuré pour traiter une pluralité de symboles en parallèle, et dans lequel l'opération de soustraction est exécutée entre deux échantillons moyennés, générés en échantillonnant chaque symbole au niveau d'un point d'échantillonnage commun et en faisant la moyenne du résultat.

**5.** Circuit détecteur de verrouillage de la récupération d'horloge (100, 200, 300, 400, 500, 600) selon une quelconque revendication précédente, dans lequel le signal de sortie est configuré pour activer un ou plusieurs modules de l'appareil récepteur de signaux (702).

**6.** Circuit détecteur de verrouillage de la récupération d'horloge (100, 200, 300, 400, 500, 600) selon une quelconque revendication précédente, dans lequel la valeur seuil de réinitialisation est un.

**7.** Circuit détecteur de verrouillage de la récupération d'horloge (100, 200, 300, 400, 500, 600) selon une quelconque revendication précédente, configuré également pour déterminer, si le compteur de verrouillage d'horloge est réinitialisé, que le circuit de récupération d'horloge (102, 202, 706) est déverrouillé, et pour émettre un signal déverrouillé en réponse à la détermination que le circuit de récupération d'horloge (102, 202, 706) est passé de verrouillé à déverrouillé.

**8.** Circuit détecteur de verrouillage de la récupération d'horloge (100, 200, 300, 400, 500, 600) selon une quelconque revendication précédente, comprenant un filtre de détection de phase (104B, 106B, 204A, 206A, 304A, 304B, 402A, 402B, 504A, 504B, 602A, 602B, 706B), PDFIL, et, éventuellement, un bloc de rééchantillonnage (104A, 106A, 302A, 302B, 502A, 502B, 706A), RES, configuré pour générer l'au moins un échantillon.

**9.** Appareil récepteur de signaux (702), comprenant :

au moins un convertisseur analogique-numérique (102, 202, 704), ADC, configuré pour quantifier un signal reçu sur la base d'un signal d'horloge de récepteur ;

un circuit de récupération d'horloge (104, 204, 706), TR, configuré pour générer un signal d'horloge pour synchroniser le signal d'horloge de récepteur avec un signal d'horloge de transmission du signal reçu ; et

le circuit détecteur de verrouillage (106, 206, 708) selon une quelconque revendication précédente.

10. Appareil récepteur de signaux (702) selon la revendication 9, dans lequel le bloc de rééchantillonnage (104A, 106A, 302A, 302B, 502A, 502B, 706A), RES, est également configuré pour générer un échantillon d'origine au niveau d'un point d'origine T = 0 du signal quantifié.

11. Appareil récepteur de signaux (702) selon la revendication 10, comprenant également un détecteur de phase (104C, 106C, 204B, 206B, 306A, 306B, 404A, 404B, 506A, 506B, 604A, 604B), PD, configuré pour générer des informations d'horloge sur la base de l'échantillon d'origine pour indiquer si le signal d'horloge de récepteur est plus rapide ou plus lent que le signal d'horloge de transmission.

12. Appareil récepteur de signaux (702) selon la revendication 9, dans lequel le circuit détecteur de verrouillage (106, 206, 708) est configuré pour générer des informations d'horloge sur la base d'au moins deux échantillons générés pour indiquer si le signal d'horloge de récepteur est plus rapide ou plus lent que le signal d'horloge de transmission.

13. Appareil récepteur de signaux (702) selon la revendication 10 ou la revendication 11, comprenant également un oscillateur commandé en tension (108, 208, 710), VCO, configuré pour générer le signal d'horloge sur la base des informations d'horloge.

14. Appareil récepteur de signaux (702) selon l'une quelconque des revendications 9 à 13, comprenant également un égaliseur (110, 210, 712), configuré pour être activé en réponse au signal de sortie provenant du circuit détecteur de verrouillage (106, 206, 708).

FIG. 1

FIG. 2

300

302A → 304A → 306A → Σ

302B → 304B → 306B → Σ

Σ (-) + Σ (+) → + → 308 → 310

## FIG. 3

400

402A → 404A → Σ

402B → 404B → Σ

Σ (-) + Σ (+) → + → 406 → 408

## FIG. 4

FIG. 5

FIG. 6

700

SIGNAL RECEIVER APPARATUS
702

704

712

706

706A

706B

710

706D

706C

708

FIG. 7

800

RECEIVING A QUANTISED SIGNAL FROM ANALOG-TO-DIGITAL CONVERTOR, ADC, OF THE SIGNAL RECEIVING APPARATUS, THE QUANTISED SIGNAL HAVING A PERIODIC UNIT INTERVAL UI
802

GENERATING AT LEAST ONE SAMPLE AT A SAMPLING POINT IN RANGE OF T= -0.25 UI TO T= +0.25 UI OF QUANTISED SIGNAL
804

PERFORMING A SUBTRACTION OPERATION BETWEEN TWO SAMPLES GENERATED FROM THE QUANTISED SIGNAL
806

INCREMENTING A TIMING LOCK COUNTER IF RESULT OF THE SUBTRACTION OPERATION IS POSITIVE
808

A

FIG. 8A

A

INCREMENTING A RESET COUNTER IF THE RESULT OF THE SUBTRACTION OPERATION IS NEGATIVE, AND RESET THE TIMING LOCK COUNTER IF THE RESET COUNTER IS ABOVE A RESET THRESHOLD VALUE
810

DETERMINING, IF THE TIMING LOCK COUNTER IS ABOVE A THRESHOLD VALUE, THAT A TIMING RECOVERY CIRCUIT OF THE SIGNAL RECEIVING APPARATUS IS LOCKED
812

GENERATING AN OUTPUT SIGNAL IN RESPONSE TO DETERMINING THAT THE TIMING RECOVERY CIRCUIT IS LOCKED
814

FIG. 8B

EP 4 360 245 B1

FIG. 9

FIG. 10A

FIG. 10B

FIG. 11A

FIG. 11B

FIG. 12A

FIG. 12B

FIG. 13A

FIG. 13B

FIG. 14A

FIG. 14B

FIG. 14C